# EUROPEAN PATENT SPECIFICATION

(11) **EP 2 042 304 B1**
(45) Date of publication and mention of the grant of the patent: **02.01.2013**
(21) Application number: 07767690.6
(22) Date of filing: 27.06.2007
(51) Int. Cl.: B41C 1/10, B41N 1/14, C09D 11/10, G03F 7/038

(54) **PLATE MAKING METHOD AND PLANOGRAPHIC PRINTING PLATE**
PLATTENHERSTELLUNGSVERFAHREN UND PLANOGRAFIEDRUCKPLATTE
PROCÉDÉ DE FABRICATION DE PLAQUE ET PLAQUE D'IMPRESSION PLANOGRAPHIQUE

(30) Priority: 14.07.2006 JP 2006193913; 20.07.2006 JP 2006197821; 20.07.2006 JP 2006197822
(43) Date of publication of application: 01.04.2009
(73) Proprietor: Konica Minolta Holdings, Inc., Tokyo 100-0005 (JP)
(72) Inventor: IIJIMA, Hirotaka, Hino-shi, Tokyo 191-8511 (JP); TSUBAKI, Yoshinori, Hino-shi, Tokyo 191-8511 (JP)
(74) Representative: Gille Hrabal
(86) International application number: PCT/JP2007/062888
(87) International publication number: WO 2008/007550

(56) References cited:
- JP-A- 04 069 244
- JP-A- 56 062 157
- JP-A- 63 102 936
- JP-A- 2006 117 795

## Description

### TECHNICAL FIELD

The present invention relates to a plate making method and a planographic printing plate, and specifically to a plate making method and a planographic printing plate employing an ink-jet recording method.

### BACKGROUND

Generally, a printing method is a recording method wherein an ink applied to a printing plate is transferred to a medium via pressure. In planography, hydrophilic portions and lipophilic portions are formed on the surface of a printing plate based on image information. Then, dampening water is applied to the hydrophilic portions, whereby a printing ink adheres only to the lipophilic portions for printing.

As a production (plate making) method of such a printing plate, there is known a method wherein a PS plate, prepared by coating a photosensitive resin on an aluminum plate, is irradiated with UV radiation based on image information through a mask prepared via a technique such as a silver halide technique, followed by washing uncured portions with an alkali to form lipophilic resins on the image portions. Further, recently, CTP (Computer to Plate) systems have emerged, wherein no mask is formed, and direct recording is carried out on a material to be used as a printing plate using laser beams based on image information in a computer, and then the printing plate is prepared via development.

The advent of such a CTP system makes it possible to reduce the processes for printing, resulting in realization of greater simplicity and speed. However, there have been problems such that even in the CPT system, development is needed in the plate making process requiring much time and effort, and also waste treatment liquids and waste materials are generated.

Further, as another method, a plate making method via an ink-jet recording method is disclosed (for example, please refer to Patent Document 1). This method is one wherein via an ink-jet recording method, an oil-based ink is applied on a printing plate material and dried to prepare a plate with residual resins corresponding to images. However, problems have been noted in that printing durability is insufficient and resolution is decreased due to so-called beading before drying of ink droplets having adhered to the surface of the printing plate.

As a method of extending printing durability, there is disclosed a plate making method wherein a radiation curable ink is applied to a hydrophilically-treated printing plate material via an ink-jet method, followed by flash exposure (for example, please refer to Patent Document 2). However, this method extends printing durability to some extent, but there have been noted such problems that beading tends to occur somewhere between ink deposition and irradiation, resulting in the tendency of decreased resolution and occurrence of dot gain. Further, another problem has been produced in that relatively high ink viscosity necessitates a special ink-jet recording head with relatively large ejection force.

Yet, as another method employing an ink-jet method, disclosed is a plate making method employing a solvent-containing-type UV curable ink wherein using an acrylate compound as a radiation curable monomer, a radiation curable ink, which is composed of a reactive diluting agent, a photopolymerization initiator, a solvent, and a dye, is applied to a printing plate material for image formation, and then the image portions are cured via radiation irradiation (for example, please refer to Patent Document 3). However, although realizing extended printing durability to some extent, this method exhibits the problem that beading is likely to occur somewhere between deposition and irradiation, resulting in the tendency of decreased resolution. Further, a decrease of the solvent amount results in a decrease in viscosity, but only a small amount of the solvent can be added to realize adequate curing sensitivity. Accordingly, there is not much difference between the case of such a viscosity decrease of the ink and the case of usage of a solvent-free UV curable ink, resulting in the problem of requiring a special ink-jet recording head with relatively large ejection force.

Still further, disclosed is a plate making method of forming hydrophobic images wherein a water-based UV curable ink, which contains an α-heteromethacrylic compound as a water-soluble polymerizable compound and also a colorant, is ejected onto a hydrophilic support, followed by curing via UV irradiation (for example, please refer to Patent Document 4). However, in this method, beading tends to occur somewhere between deposition and irradiation, resulting in the adverse tendency of decreased resolution. In addition, ink receptivity of printing ink with respect to image portions is insufficient, leading to non-uniform printed density.
Patent Document 1: Unexamined Japanese Patent Application Publication No. (hereinafter also referred to as JP-A) 56-62157
Patent Document 2: JP-A 4-69244
Patent Document 3: JP-A 63-102936
Patent Document 4: JP-A 2006-117795

### DISCLOSURE OF THE INVENTION

### PROBLEMS TO BE SOLVED BY THE INTENTION

In view of the above problems, the present invention was achieved. An object of the present invention is to improve printing durability, resolution, and ink receptivity which have been problematic in plate making via an ink-jet method, and also to provide a plate making method enabling plate making using a simple apparatus employing an ink-jet ink featuring enhanced curing sensitivity and relatively low viscosity, as well as a planographic printing plate produced via the plate making method, by utilizing the characteristics of the ink-jet method featuring simplicity and high productivity potential.

### MEANS TO SOLVE THE PROBLEMS

The above object of the present invention can be achieved via the following constitutions:
Item 1. A plate making method comprising the steps of:
   (1) ejecting a plate making ink onto a printing plate material via an ink-jet recording method, (2) irradiating actinic energy rays onto the ejected plate making ink, and (3) forming an image via evaporating of an ink solvent followed by drying,
   wherein the plate making ink comprises at least water and an actinic energy ray curable polymer, having a plurality of side chains with a main chain, and cross-linking can be induced among the side chains by irradiation of actinic energy ray radiation, and having a polymerization degree of 200 - 4000, in a range of 0.8% - 5.0 weight% based on the total weight of the ink.
Item 2. The plate making method described in item 1 above, wherein the main chain of the actinic energy ray curable polymer is a saponified compound of polyvinyl acetate and the saponification degree is 77% - 99%.
Item 3. The plate making method described in item 1 or 2 above, wherein a modification rate of the side chains is 0.8 mol% - 6 mol% based on the main chain of the actinic energy ray curable polymer.
Item 4. The plate making method described in any one of items 1 - 3 above, wherein the plate making ink contains resin fine particles of an average particle diameter of 5 nm - 150 nm in the range of 0.1 weight% - 7 weight% based on the total weight of the ink.
Item 5. The plate making method described in item 4 above, wherein the glass transition point of the resin fine particles is -20 °C to 70 °C.
Item 6. The plate making method described in any one of items 1 - 5 above, wherein the plate making ink contains an alkali-soluble polymer with no cross-linking group, composed of a copolymer of a hydrophilic compound and a hydrophobic compound, in the range of 0.1 weight% - 10 weight% based on the total weight of the ink.
Item 7. The plate making method described in item 6 above, wherein an alkaline agent used to solubilize the alkali-soluble polymer is a compound containing an organic base having a vapor pressure of 133 Pa - 1330 Pa at 20 °C or ammonia.
Item 8. The plate making method described in item 6 or 7 above, wherein a weight average molecular weight of the alkali-soluble polymer is 3000 - 20000.
Item 9. A planographic printing plate produced via the plate making method described in any one of items 1 - 8 above.

### EFFECTS OF THE INVENTION

According to the present invention, by utilizing the characteristics of an ink-jet method featuring simplicity and high productivity potential, there was able to be improved printing durability, resolution, and ink receptivity which have been problematic in plate making via the ink-jet method, and also there were able to be provided a plate making method enabling plate making using a simple apparatus employing an ink-jet ink featuring enhanced curing sensitivity and relatively low viscosity, and also a planographic printing plate produced via the plate making method.

### BRIEF DESCRIPTION OF THE DRAWING

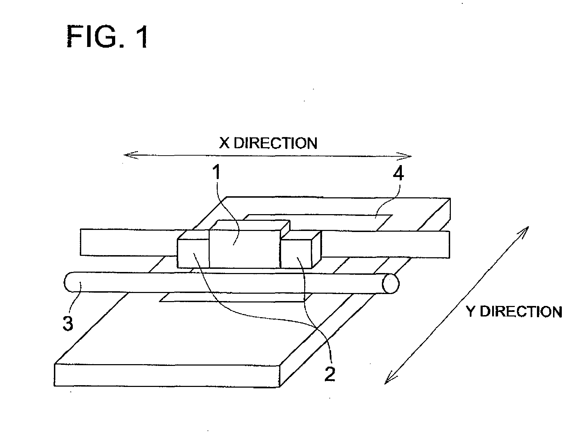

[FIG. 1] An oblique perspective view showing one example of an ink-jet printer applicable to the plate making method of the present invention.

### DESCRIPTION OF THE NUMERIC DESIGNATIONS

1: carriage
2: UV irradiation source
3: conveyance roller
4: plate material

### BEST MODE TO CARRY OUT THE INVENTION

The best mode to carry out the present invention will now be detailed.

In view of the above problems, the present inventors conducted diligent investigations. Thereby, in a plate making method wherein a plate making ink is applied on a printing plate material via an ink-jet recording method and irradiated with actinic energy ray radiation, and an ink solvent is evaporated, followed by drying to carry out image formation, via a plate making method wherein the plate making ink contains at least water and an actinic energy ray curable polymer, having a main chain with a plurality of side chains among which cross-linking can be induced by irradiation of actinic energy ray radiation and having a polymerization degree of 200 - 4000, in the range of 0.8 weight% - 5.0 weight% based on the total weight of the ink, the present inventors were able to improve printing durability, resolution, and ink receptivity which have been problematic in plate making via an ink-jet method, and also to provide a plate making method enabling plate making using a simple apparatus employing an ink-jet ink featuring enhanced curing sensitivity and relatively low viscosity, by utilizing the characteristics of the ink-jet method featuring simplicity and high productivity potential.

In a conventional actinic energy ray curable ink-jet ink, all of the materials constituting the ink were curing components; or even when an organic solvent or water was contained therein, no curing was induced with a small content of a curable resin. Therefore, there has been noted the problem that practical sensitivity (the amount of radiation required to realize hardness provided for printing durability) was unachievable. When a needed amount of the curable rein was added, the viscosity of the ink-jet ink exceeded 20 mPa·s, whereby ink-jet ejection failure has frequently occurred.

The present invention is characterized by employing an actinic energy ray curable polymer having a main chain with a plurality of side chains among which cross-linking can be induced by irradiation of actinic energy ray radiation and having a polymerization degree of 200 - 4000. Using this actinic energy ray curable polymer, there was realized a plate making ink, which was curable with actinic energy ray radiation even at a small content rate and exhibited practical sensitivity and relatively low viscosity. Thus, a plate making method featuring high precision and high productivity potential was realized.

Further, in producing a printing plate employing a conventional actinic energy ray curable ink, an ink used as described above is composed mostly of an actinic energy ray curable component. Thereby, printed portions formed (plate side) tended to be raised, resulting in a bulky shape (e.g., about 10 µm high). Accordingly, when printing was carried out by ejecting a printing ink thereon, the raised printed portions (plate side) were flattened or spread, resulting in the problem of increasing dot gain, which has caused decreased resolution. In contrast, in a plate making ink applied to the present invention, since the content of an actinic energy ray curable component was able to be set to be extremely low, a large amount of an evaporating component was able to be contained in the plate making ink. Therefore, the height of printed portions after printing and drying was able to be controlled to be small, and also enhanced resolution was realized due to excellent flatness, whereby a printing plate with high image quality became able to be produced.

An actinic energy ray curable polymer according to the present invention, having a main chain with a plurality of side chains among which cross-linking can be induced by irradiation of actinic energy ray radiation and having a polymerization degree of 200 - 4000, is hydrophilic and soluble in water or a water-soluble organic solvent before cross-linked. However, via cross-linking, the hydrophobic properties increase, whereby using for a planographic printing plate material makes it possible to enhance printing durability and water resistance.

Namely, since hydrophilic properties are provided in the ink state, affinity for the substrate of a printing plate is enhanced, whereby adhesion between ink and the substrate can be increased. After curing via irradiation of actinic energy ray radiation, hydrophobic properties (lipophilic properties) are exhibited, and then affinity for the printing ink is enhanced, whereby easy ink acceptability is imparted to a planographic printing plate as its favorable characteristics.

Generally, offset printing employing a planographic printing plate is a printing method wherein a thin water film is formed on a non-image portion of a printing plate to repel lipophilic ink; then the ink is accepted only by a lipophilic image portion; and an ink layer, having been formed on the surface of the printing plate in an imagewise manner, is transferred onto paper via a rubber roller.

According to the planographic printing plate of the present invention, a planographic printing plate most suitably used in an offset method is provided, wherein as described above, the plate making ink to form a lipophilic image portion is applied on a hydrophilic substrate via an ink-jet method to allow the non-image portion and the image portion to differ in hydrophilic properties and lipophilic properties.

Further, in the plate making method of the present invention, there is enhanced, via cross-linking, hydrophobic properties of an actinic energy ray curable polymer contained in a plate making ink having a main chain with a plurality of side chains among which cross-linking can be induced by irradiation of actinic energy ray radiation and having a polymerization degree of 200 - 4000. Thereby, image portions, to which the ink adheres, are formed.

In a curing component used for a conventional actinic energy ray curable ink, since the molecular weight of the curing component is small, no hardness is exhibited with a small amount. Therefore, a large amount thereof is required for enhancing hardness. In contrast, a small amount thereof results in decreased sensitivity. Accordingly, since a large amount of the curing component is required, viscosity of the ink inevitably becomes larger.

Further, in order to increase curing sensitivity even to a small extent, there have been attempts to add an oligomer or prepolymer wherein a curing component is cross-linked at least 2 points, which is, however, inefficient in decreasing the amount of the curing component. Also, ink viscosity remains high due to high viscosity of the oligomer or prepolymer.

On the other hand, a curing component contained in a plate making ink according to the present invention is structured in such a manner that a cross-linking group is attached, as a side chain, to the main chain of a high molecular weight component. With this structure, curing can be realized using the component of a small amount of 0.8 weight% - 5.0 weight% based on the total weight of the plate making ink, although the mechanism is unclear.

Further, an actinic energy ray curable polymer according to the present invention features a polymerization degree of 200 - 4000. When the polymerization degree is at most 4000, an excessive increase in ink viscosity is prevented, whereby stable ejection performance can be achieved. When the modification rate of side chains is 0.8 mol% - 6 mol%, sensitivity enhancement is specifically pronounced.

In the plate making method of the present invention, one of the preferred embodiments is that a plate making ink according to the present invention contains an actinic energy ray curable polymer having the above main chain with a plurality of side chains among which cross-linking can be induced by irradiation of actinic energy ray radiation and having a polymerization degree of 200 - 4000, as well as an alkali-soluble polymer with no cross-linking group compose of a copolymer of a hydrophilic compound and a hydrophobic compound in the range of 0.1 weight% - 10 weight%.

Namely, the plate making ink of the present invention improves ink receptivity of the printing ink by further adding an alkali-soluble polymer with no cross-linking group compose of a copolymer of a hydrophilic compound and a hydrophobic compound. It is thought that of various resins, when any resin selected from the copolymers having a hydrophilic portion and a hydrophobic portion is contained, the printing ink exhibits affinity for the hydrophobic portion of this resin, resulting in improved ink receptivity. Herein, this alkali-soluble resin may be used individually, or plural compounds of such a type may be used in combination.

Further, when an alkaline agent added to solubilize an alkali-soluble resin is an organic base exhibiting a vapor pressure of 133 Pa - 1330 Pa at 20 °C or ammonia, printing durability is extended and then ink receptivity of printing ink are also enhanced via realization of insolubility to water after recording on a plate material, drying, and curing.

Furthermore, in the plate making method of the present invention, one of the preferred embodiments is also that a plate making ink according to the present invention contains an actinic energy ray curable polymer having the above main chain with a plurality of side chains among which cross-linking can be induced by irradiation of actinic energy ray radiation and having a polymerization degree of 200 - 4000, as well as a resin fine particle of an average particle diameter of 5 nm - 150 nm in the range of 0.1 weight% - 7 weight%.

Namely, when the plate making ink of the present invention further contains a resin fine particle of an average particle diameter of 5 nm - 150 nm in the range of 0.1 weight% - 7 weight%, ink receptivity of the printing ink are improved. The average particle diameter of the resin fine particle is critical to an ink-jet plate making method. Namely, in the case of at least 5 nm, an improved effect on ink receptivity can be expressed. When the average particle diameter is at most 150 nm, stability of ejection from an ink-jet head can be ensured. Thereby, there are realized excellent fine line reproducibility and small-sized character reproducibility in producing a printing plate which requires enhanced deposition accuracy. Further, the amount of the resin fine particle added is a factor affecting ink receptivity themselves. In the case of at least 0.1 weight%, an effect on ink receptivity was produced. In the case of at most 7 weight%, adequate ink receptivity were realized and also nozzle clogging during intermittent ejection was prevented, resulting in realization of ejection stability.

The present invention will now be detailed.

Initially, a plate making ink (hereinafter also referred to simply as "ink") according to the plate making method of the present invention will now be described.

### [Actinic Energy Ray Curable Polymer]

An actinic energy ray curable polymer according to the present invention having a main chain with a plurality of side chains among which cross-linking can be induced by irradiation of actinic energy ray radiation is those wherein a modification group of a photodimerization type, photodecomposition type, photopolymerization type, photomodification type, or photodepolymerization type is introduced into side chains of at least one type of resin selected from the group including a saponified compound of polyvinyl acetate, polyvinyl acetal, polyethylene oxide, polyalkylene oxide, polyvinyl pyrrolidone, polyacrylamide, polyacrylic acid, hydroxyethyl cellulose, methyl cellulose, hydroxypropyl cellulose, or a derivative of any of the above resins, and a copolymer thereof. Of these, a photopolymerization type cross-linkable group is preferable from the viewpoint of performance of images formed.

Further, one of the features of the present invention is that the polymerization degree of the actinic energy ray curable polymer is 200 - 4000, and preferably 200 - 2000 from the viewpoint of handling.

In the main chain, in view of simplicity and handling with respect to introduction into side chains, a saponified compound of polyvinyl acetate is preferable. The modification rate of the side chains is preferably 0.3 mol% - 6 mol% based on the main chain, but more preferably 0.8 mol% - 6 mol% from the viewpoint of reactivity. When the modification rate of the side chains is at least 0.3 mol% based on the main chain, adequate cross-linking performance is realized, resulting in producing the effects of the present invention. In contrast, in the case of at most 6 mol%, cross-linking density tends not to excessively increase, whereby hard and fragile film formation and film strength decrease can be prevented.

As a photodimerization type modification group, preferable are those introduced with a diazo group, cinnamoyl group, stilbazolinium group, or styrylquinolinium group. There are listed the photosensitive resins (compositions) described, for example, in patent publications such as JP-A No. 60-129742.

The photosensitive resin described in JP-A No. 60-129742 is a compound, represented by following Formula (1), wherein a stilbazolinium group is introduced into a polyvinyl alcohol structural body.

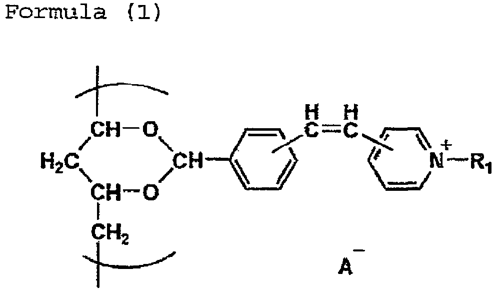

In Formula (1), R₁ represents an alkyl group having 1 - 4 carbon atoms and A⁻ represents a counter anion.

The photosensitive resin described in JP-A No. 56-67309 is a resin composition having a 2-azido-5-nitrophenylcarbonyloxyethylene structure represented by following Formula (2) or a 4-azido-3-nitrophenylcarbonyloxyethylene structure represented by following Formula (3) in its polyvinyl alcohol structural body.

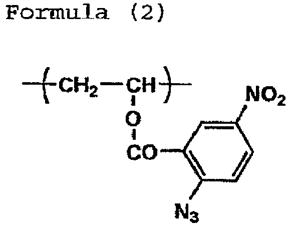

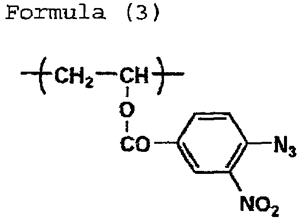

Further, the modification group represented by following Formula (4) is preferably used.

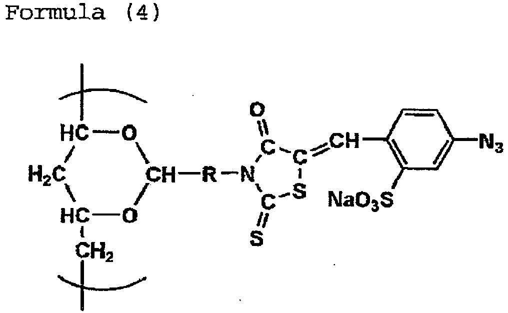

In Formula (4), R represents an alkylene group or an aromatic ring, but a benzene ring is preferable.

As a photopolymerization type modification group, the resin represented by following Formula (5), as disclosed, for example, in JP-A Nos. 2000-181062 and 2004-189841 is preferable from the viewpoint of reactivity.

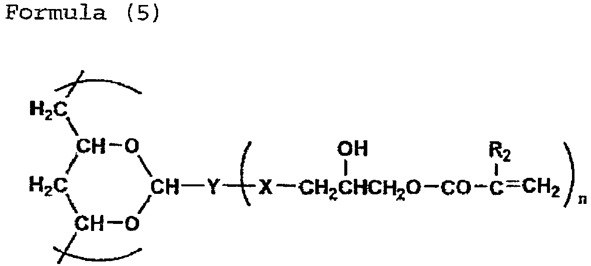

In Formula (5), R₂ represents a methyl group or a hydrogen atom; n represents 1 or 2; X represents -(CH₂)ₘ-COO-or -O-; Y represents an aromatic ring or a single bonding unit; and m represents an integer of 0 - 6.

The photopolymerization type modification group represented by following Formula (6), as described in JP-A No. 2004-161942, is also preferably used for a water-soluble resin conventionally known in the art.

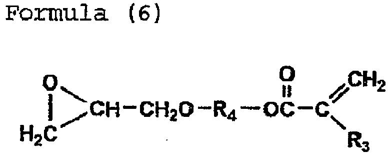

In Formula (6), R₃ represents a methyl group or a hydrogen atom, and R₄ represents a straight-chained or branched alkylene group having 2 - 10 carbon atoms.

Such an actinic energy ray radiation cross-linking type resin is, as one of its features, contained in the range of 0.8 weight% - 5.0 weight% based on the total ink weight. When the resin exists at 0.8 weight% or more, cross-linking efficiency is enhanced, and then beading and color bleeding become further favorable via a rapid increase in ink viscosity after cross-linking. In the case of at most 5.0 weight%, physical properties of the ink and the state within the ink head are barely affected adversely, resulting in preferable ejection performance and ink storage stability.

In an actinic energy ray radiation cross-linking type polymer according to the present invention, the main chain, which has a polymerization degree to some extent on its own, is cross-linked via cross-linking among side chains. Accordingly, a molecular increasing effect per photon is extremely large, compared to that of an actinic energy ray radiation curing type resin, which is polymerized via common chain reaction. In contrast, in an actinic energy ray radiation curing type polymer conventionally known in the art, the number of cross-linking points is uncontrollable. Therefore, physical properties of a film after cured are uncontrollable, whereby a hard and fragile film tends to result.

In a resin used for the present invention, the number of cross-linking points is totally controllable via adjustment of the length of the main chain and the introducing amount into side chains. Thereby, it is possible to control physical properties of the ink film for different purposes.

Further, since nearly the entire amount of an actinic energy ray radiation curing type ink, other than a colorant, is occupied by a curable component, ink dots after curing are raised, resulting in a thickened plate which tends to cause dot gain. In contrast, in a plate making method using an ink employing a resin used for the present invention, the amount of the resin added is relatively small and the amount of dry components is relatively large, whereby no unnecessarily raised dots are generated after curing, resulting in formation of a printing plate exhibiting excellent final print quality.

### [Photopolymerization Initiators and Sensitizing Agents]

In the present invention, a photopolymerization initiator and a sensitizing agent are also preferably added. These compounds may be dissolved or dispersed in a solvent, or chemically bonded to a photosensitive resin.

Any of such a photopolymerization initiator and a sensitizing agent is applicable with no specific limitation, and those conventionally known in the art can be used.

Although any photopolymerization initiator and sensitizing agent is applicable with no specific limitation, a water-soluble compound is preferable from the viewpoint of mixing properties and reaction efficiency. Especially, 4-(2-hydroxyethoxy)phenyl-(2-hydroxy-2-propyl)ketone (HMPK), thioxythanthone ammonium salt (QTX), and benzophenone ammonium salt (ABQ) are preferable from the viewpoint of properties of mixing with a water-based solvent.

Further, from the viewpoint of compatibility with a resin, more preferable are 4-(2-hydroxyethoxy)phenyl-(2-hydroxy-2-propyl)ketone (n = 1, HMPK) and also its ethylene oxide adducts (n = 2 - 5), represented by following Formula (7). 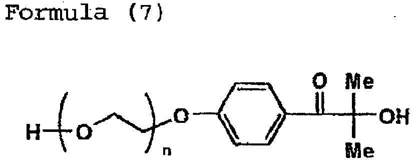 wherein n represents an integer of 1 - 5.

In addition thereto, there are preferably used, for example, benzophenones such as benzophenone, hydroxybenzophenone, bis-N,N-dimethylaminobenzophenone, bis-N,N-diethylaminobenzophenone, or 4-methoxy-4'-dimethylaminobenzophenone; thioxanthones such as thioxthantone, 2,4-diethylthioxthantone, isopropylthioxthantone, chlorothioxthantone, or isopropoxychlorothioxthantone; anthraquinones such as ethylanthraquinone, benzanthraquinone, aminoanthraquinone, or chloroanthraquinone; acetophenones; benzoin ethers such as benzoin methyl ether; 2,4,6-trihalomethyltriazines; 1-hydroxycyclohexyl phenyl ketone; 2,4,5-triarylimidazole dimmers such as a 2-(o-chlorophenyl)-4,5-diphenylimidazole dimer, 2-(o-chlorophenyl)-4,5-di(m-methoxyphenyl)imidazole dimmer, 2-(o-fluorophenyl)-4,5-diphenylimidazole dimer, 2-(o-methoxyphenyl)-4,5-diphenyimidazole dimer, 2-(p-methoxyphenyl)-4,5-diphenyimidazole dimer, 2-di(p-methoxyphenyl)-5-phenyimidazole dimer, or 2-(2,4-dimethoxyphenyl)-4,5-diphenyimidazole dimer; benzyldimethy ketal; 2-benzyl-2-dimethylamino-1-(4-morphorinophenyl)-butane-1-one ; 2-methyl-1-[4-(methylthio)phenyl]-2-morphorino-1-propanone; 2-hydroxy-2-methyl-1-phenyl-propane-1-one; 1-[4-(2-hydroxyethoxy)-phenyl]-2-hydroxy-2-methyl-1-propane-1-one; phenanthrenquinone; 9,10-phenanthrenequinone; benzoins such as methylbenzoin or ethylbenzoin; acrydine derivatives such as 9-phenylacrydine or 1,7-bis(9,9'-acrydinyl)heptane; bisacylphosphine oxide; and mixtures thereof. These may be used individually or in combination.

In addition to these photopolymerization initiators, substances such as an accelerator may be added. Examples thereof include p-dimethylamino ethyl benzoate, p-dimethylamino isoamyl benzoate, ethanolamine, diethanolamine, and triethanolamine. In any of these photopolymerization initiators, the main chain is also preferably grafted to side chains.

### [Alkali-soluble Polymers]

In the plate making method of the present invention, the above plate making ink preferably contains an actinic energy ray curable polymer having a main chain with a plurality of side chains among which cross-linking can be induced by irradiation of actinic energy ray radiation and having a polymerization degree of 200 - 4000, as well as an alkali-soluble polymer with no cross-linking group compose of a copolymer of a hydrophilic compound and a hydrophobic compound in the range of 0.1 weight% - 10 weight%.

As the alkali-soluble polymer of the present invention, an alkali-soluble copolymerized resin, which is a copolymer of a hydrophilic compound and a hydrophobic compound, is used. As the hydrophilic compound which is a monomer of the alkali-soluble copolymerized resin, there are used, for example, compounds prepared by substituting compounds having an acrylic group, methacrylic group, vinyl group, ether group, maleic acid group, or maleic anhydride group with a hydrophilic group such as a sulfonic group, carboxyl group, hydroxyl group, amide group, amino group, ether group, or pyrrolidone group. As the hydrophobic compound, for example, styrene, an acrylic acid ester, and isobutylene are used. Specific examples of the alkali-soluble copolymerized resin include a styrene-acrylic acid resin, a styrene-acrylic acid-acrylic acid ester resin, a styrene-maleic acid resin, a styrene-maleic acid half-ester resin, an isobutylene-maleic anhydride resin, and a rosin-modified maleic acid resin; and in addition thereto, include a water-soluble alkyd, a water-soluble polyester, and a water-soluble polyamide.

The weight average molecular weight of an alkali-soluble polymer used in the present invention is preferably 3000 - 20000. When the molecular weight of the alkali-soluble polymer to be added to the ink is at most 20000, clogging in the ink-jet head can be prevented and further ejection stability such as prevention of satellite occurrence during ejecting or prevention of variation of the ejected droplet amount can be maintained. The weight average molecular weight referred to in the present invention can be determined, for example, via a GPC (gel permeation chromatography) method.

The added amount of the alkali-soluble polymer of the present invention is preferably 0.1 weight% - 10 weight%, specifically preferably 1 weight% - 5 weight% based on the total weight of the ink. When the added amount is at least 0.1 weight%, a sufficient effect on ink receptivity is expressed. In the case of at most 10 weight%, occurrence of ejection instability factors such as a capping phenomenon of the head meniscus and variation of the droplet amount can be prevented.

### [Alkaline Agents]

As an alkaline agent used to solubilize the alkali-soluble polymer, there are used, for example, sodium hydroxide, sodium carbonate, ammonium carbonate, ammonia, sodium acetate, ammonium acetate, and morpholine, as well as alkanol amines such as monoethanolamine, diethanolamine, triethanolamine, ethylmonoethanolamine, n-butylmonoethanolamine, dimethylethanolamine, diethylethanolamine, ethyldiethanolamine, n-butyldiethanolamine, di-n-butylethanolamine, mono-isopronolamine, di-isopropanolamine, or tri-isopropanolamine. Of these, an organic base featuring a vapor pressure of 133 Pa - 1330Pa at 20 °C, and ammonia are preferable.

The amount of the alkaline agent added is preferably at least the neutralization equivalent of the alkali-soluble polymer of the present invention. The added amount is more preferably is equal to or 3 times the neutralization equivalent in terms of the number of moles. Herein, the number of moles of a basic compound required to neutralize 1 g of a resin is determined by the following expression based on the acid value of the resin: alkaline agent amount needed (mol/g of resin) = (acid value of resin)/56000.

### [Resin Fine Particles]

In the plate making method of the present invention, one of the preferred embodiments is that the above plate making ink contains an actinic energy ray curable polymer having a main chain with a plurality of side chains among which cross-linking can be induced by irradiation of actinic energy ray radiation and having a polymerization degree of 200 - 4000, as well as a resin fine particle of an average particle diameter of 5 nm - 150 nm in the range of 0.1 weight% - 7 weight%.

The resin fine particle of the present invention is not specifically limited, including resin fine particles composed preferably of polyurethane, polystyrene-acryl, polystyrene-butadiene, polystyrene-maleic acid, polyester, polyether, polycarbonate, polyamide, polyacrylonitrile, polystyrene, polybutadiene, polyacrylic acid, polymethacrylic acid, polyvinyl chloride, polyvinylidene chloride, polyvinyl acetate, acrylic-modified silicone resins, or acrylic-modified fluororesins, as well as resin fine particles composed of copolymers or salts thereof. Of these, preferable is at least one type of copolymer selected from polyurethane, as well as polystyrene-acrylic, polystyrene-butadiene, and polystyrene-maleic acid copolymers.

In the ink of the present invention, the average particle diameter of the resin fine particle is preferably 5 nm - 150 nm. When the average particle diameter of the resin fine particle is at least 5 nm, the effect of improving ink receptivity is expressed. When the particle diameter is at most 150 nm, stability of ejection from the ink-jet head can be maintained. Thereby, there are realized fine line reproducibility and small character reproducibility in producing a printing plate which demands enhanced deposition accuracy. The average particle diameter of the resin fine particle of the present invention can be determined using a commercially available particle diameter measuring instrument employing a light scattering method, an electrophoretic method, or a laser Doppler method.

Further, in the ink of the present invention, the content of the resin fine particle of the present invention is preferably 0.1 weight% - 7 weight%, more preferably 0.1 weight% - 5 weight% based on the total weight of the ink. When the content of the resin fine particle of the present invention is at least 0.1 weight%, an excellent effect on ink receptivity is expressed. In the case of at most 7 weight%, adequate ink receptivity can be realized, and also nozzle clogging, resulting from the resin fine particle, during intermittent ejection can be prevented. Furthermore, viscosity of the ink is usually increased as resin fine particles are added. With such an increase of the ink viscosity, no ejection is realized at a relatively high drive frequency, resulting in decreased productivity. Therefore, additionally, considering the ink viscosity, the added amount is preferably at most 5 weight%.

The resin fine particle of the present invention may be either a forced emulsification type wherein emulsifying is forcibly carried out using an emulsifying agent, or a self-emulsification type wherein a resin added with a hydrophilic group or hydrophilic segment is dispersed. As the emulsifying agent, a surfactant is frequently used. It is also preferable to use a polymer having a hydrophilic group such as a sulfonic acid group or a carboxylic acid group (for example, a hydrophilic group graft-bonded polymer and a polymer composed of a monomer having a hydrophilic portion and a monomer having a hydrophobic portion).

Recently, as latex polymer particles, in addition to latexes wherein polymer particles with entire particle uniformity are dispersed, there exist latexes wherein polymer particles of a core-shell type with different compositions in the center portion and the outer portion of the particles are dispersed. Latexes of such a type are also preferably used.

The resin fine particle of the present invention is preferably nonionic or anionic from the viewpoint of storage stability.

The glass transition point (Tg) of the resin fine particle of the present invention is preferably -20 °C - 70 °C. When the resin has a glass transition point of at least -20 °C, scratch resistance and rubbing resistance can be maintained in cases of being used for a plate. When the glass transition point is at most 70 °C, smoothing can be realized with no residual shape of the resin fine particle used, and the resin ensures a sufficient hardness range, whereby ink receptivity of the ink become enhanced. The glass transition point can be determined via a method known in the art utilizing discontinuous changes of the thermal expansion coefficient and specific heat in the course of temperature change.

### [Colorants]

A plate making ink used for the plate making method of the present invention may be a clear ink containing no colorants, however, being preferably a colored ink containing colorants in order to easily identify patterns drawn on a printing plate.

The content of the colorants may be smaller than that of an ink-jet ink used for image formation, being preferably 0.1 weight% - 3 weight% based on the total ink weight. The type of the colorants may be either a dye or a pigment.

### (Dyes)

Dyes usable for the present invention are not specifically limited, including water-soluble dyes and dispersion dyes such as acidic dyes, direct dyes, or reactive dyes.

Specific examples of such dyes applicable to the ink of the present invention will now be listed. However, the present invention is not limited only to these exemplified dyes.

### <Water-soluble dyes>

Water-soluble dyes usable for the present invention include, for example, azo dyes, methine dyes, azomethine dyes, xanthene dyes, quinone dyes, phthalocyanine dyes, triphenylmethane dyes, and diphenylmethane dyes.

Further, as such dyes, the compound represented by following Formula (8) or the compound represented by following Formula (9) can also be used.

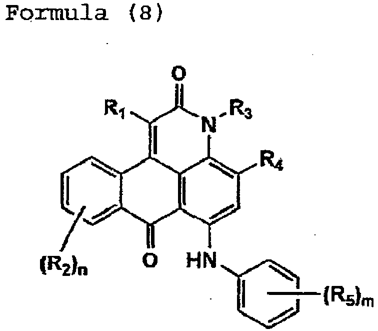

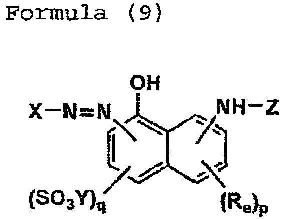

In Formula (8), R₁ represents a hydrogen atom or a substitutable substituent, being preferably a hydrogen atom or a phenyl carbonyl group; R₂, which may differ, represents a hydrogen atom or a substitutable substituent, being preferably a hydrogen atom; R₃ represents a hydrogen atom or a substitutable substituent, being preferably a hydrogen atom or an alkyl group; R₄ represents a hydrogen atom or a substitutable substituent, being preferably a hydrogen atom or an aryloxy group; R₅, which may differ, represents a hydrogen atom or a substitutable substituent, being preferably a sulfonic acid group; n represents an integer of 1 - 4; and m represents an integer of 1 - 5.

In Formula (9), X represents a phenyl group or a naphthyl group, which may be substituted with a substitutable substituent, being preferably substituted with a sulfonic acid group or a carboxyl group; Y represents a hydrogen ion, a sodium ion, a potassium ion, a lithium ion, an ammonium ion, or an alkyl ammonium ion; R₆, which may differ, represents a hydrogen atom or a substituent with which the naphthalene ring can be substituted; q represents 1 or 2 and p represents an integer of 1 - 4, provided that p + q = 5; and Z represents a substitutable group, specifically representing a carbonyl group, a sulfonyl group or the group represented by following Formula (10), and of these, the group represented by following Formula (10) is specifically preferable.

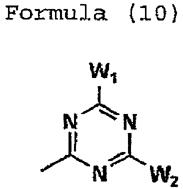

In Formula (10), W₁ and W₂, which each may differ, represent a halogen atom, a hydroxyl group, an alkylamino group, or an arylamino group. Of these, a halogen atom, a hydroxyl group, or an alkylamino group is preferable.

### <Dispersion Dyes>

As dispersion dyes, there can be used dispersion dyes such as azo dispersion dyes, quinone dispersion dyes, anthraquinone dispersion dyes, or quinophthalone dispersion dyes.

### (Pigments)

As pigments usable for the present invention, conventionally known ones can be used with no specific limitation. Both water dispersible pigments and solvent dispersible pigments can be used. Organic pigments such as insoluble pigments or lake pigments and inorganic pigments such as carbon black can preferably be used. These pigments are allowed to exist in the state of being dispersed in the ink. Methods for such dispersion may be any one of self dispersion, dispersion using a surfactant, polymer dispersion, and micro-capsule dispersion.

The insoluble pigments are not specifically limited. Preferable are, for example, azo, azomethine, methine, diphenylmethane, triphenylmethane, quinacridone, anthraquinone, perylene, indigo, quinophthalone, isoindolinone, isoindoline, azine, oxazine, thiazine, dioxazine, thiazole, phthalocyanine and diketopyrrolopyrrole.

Specific pigments to be preferably used include the following ones.

Magenta or red pigments include, for example, C. I. Pigment Red 2, C. I. Pigment Red 3, C. I. Pigment Red 5, C. I. Pigment Red 6, C. I. Pigment Red 7, C. I. Pigment Red 15, C. I. Pigment Red 16, C. I. Pigment Red 48:1, C. I. Pigment Red 53:1, C. I. Pigment Red 57:1, C. I. Pigment Red 122, C. I. Pigment Red 123, C. I. Pigment Red 139, C. I. Pigment Red 144, C. I. Pigment Red 149, C. I. Pigment Red 166, C. I. Pigment Red 177, C. I. Pigment Red 178, C. I. Pigment Red 202, C. I. Pigment Red 222, and C. I. Pigment Violet 19.

Orange or yellow pigments include, for example, C. I. Pigment Orange 31, C. I. Pigment Orange 43, C. I. Pigment Yellow 12, C. I. Pigment Yellow 13, C. I. Pigment Yellow 14, C. I. Pigment Yellow 15, C. I. Pigment Yellow 15:3, C. I. Pigment Yellow 17, C. I. Pigment Yellow 74, C. I. Pigment Yellow 93, C. I. Pigment Yellow 128, C. I. Pigment Yellow 94, and C. I. Pigment Yellow 138.

Green or cyan pigments include, for example, C. I. Pigment Blue 15, C. I. Pigment Blue 15:2, C. I. Pigment Blue 15:3, C. I. Pigment Blue 16, C. I. Pigment Blue 60, and C. I. Pigment Green 7.

Further, black pigments include, for example, C. I. Pigment Black 1, C. I. Pigment Black 6, and C. I. Pigment Black 7.

The average particle diameter of a dispersed pigment contained in the ink of the present invention is preferably 50 nm - 200 nm.

The particle diameter of a pigment dispersion can be determined using a commercially available particle diameter measuring instrument employing a dynamic light scattering method or an electrophoretic method. Determination via the dynamic light scattering method is frequently employed due to ease and convenience, and excellent accuracy in this particle diameter range.

Pigments used for the ink of the present invention are preferably used via dispersion together with a dispersant and an appropriate additive, according to intended purposes, using a homogenizer. As the homogenizer, a ball mill, sand mill, line mill, or high pressure homogenizer conventionally known in the art can be used. Of these, it is preferable to produce an ink via dispersion using a sand mill, since particle distribution of the ink is narrow. Further, a material for beads used in this sand mill dispersion are preferably zirconia or zircon in view of contamination of bead fragments and ion components. The diameter of such beads is preferably 0.3 mm - 3 mm.

When a pigment to be contained in the ink of the present invention is dispersed, a surfactant and a polymer dispersant can be used as the above dispersant individually or in combination.

### [Water-soluble Solvents]

Solvents constituting the ink of the present invention contain at least water, and may further contain a water-soluble organic solvent.

Examples of the water-soluble solvent applicable to the ink of the present invention include alcohols (e.g., methanol, ethanol, propanol, isopropanol, butanol, isobutanol, sec-butanol, and tert-butanol), polyhydric alcohols (e.g., ethylene glycol, diethylene glycol, triethylene glycol, polyethylene glycol, propylene glycol, dipropylene glycol, polypropylene glycol, butylene glycol, hexanediol, pentanediol, glycerin, hexanetriol, and thiodiglycol), polyhydric alcohol ethers (e.g., ethylene glycol monomethyl ether, ethylene glycol monoethyl ether, ethylene glycol monobutyl ether, diethylene glycol monomethyl ether, diethylene glycol monoethyl ether, diethylene glycol monobutyl ether, propylene glycol monomethyl ether, propylene glycol monobutyl ether, ethylene glycol monomethyl ether acetate, triethylene glycol monomethyl ether, triethylene glycol monoethyl ether, triethylene glycol monobutyl ether, ethylene glycol monophenyl ether, and propylene glycol monophenyl ether), amines (e.g., ethanolamine, diethanolamine, triethanolamine, N-methyldiethanolamine, N-ethyldiethanolamine, morpholine, N-ethylmorpholine, ethylenediamine, diethylenediamine, triethylenetetramine, tetraethylenepentamine, polyethyleneimine, pentamethyldiethylenetriamine, and tetramethylpropylenediamine), amides (e.g., formamide, N,N-dimethylformamide, and N,N-dimethylacetamide), heterocycles (e.g., 2-pyrrolidone, N-methyl-2-pyrrolidone, cyclohexyl pyrrolidone, 2-oxazolidone, and 1,3-dimethyl-2-imidazolidinone), and sulfoxides (e.g., dimethylsulfoxide).

The total amount of the solvent (water alone or a mixture of water and a water-soluble organic solvent) contained in the ink of the present invention is preferably 50 weight% - 98 weight%, more preferably 80 weight% - 98 weight% based on the total ink weight. Further, water is preferably contained in the range of 50 weight% - 80 weight% based on the total ink weight.

### [Surfactants]

The ink of the present invention may contain surfactants.

The surfactants preferably applicable to the ink of the present invention include anionic surfactants such as alkyl sulfuric acid salts, alkyl ester sulfuric aid salts, dialkylsulfosuccinic acid salts, alkylnaphthalene sulfonic acid salts, alkyl phosphoric acid salts, polyoxyalkylene alkyl ether phosphoric acid salts, or fatty acid salts; nonionic surfactants such as polyoxyethylene alkyl ethers, polyoxyalkylene alkylphenyl ethers, acetylene glycols, or polyoxyethylene-polyoxypropylene block copolymers; surfactants such as glycerin esters, sorbitan esters, polyoxyethylene fatty acid amides, or amine oxides; and cationic surfactants such as alkyl amine salts or quaternary ammonium salts.

These surfactants may be use as a dispersant for a pigment. Anionic and nonionic surfactants can specifically preferably be employed.

### [Various Additives]

In the present invention, other additives conventionally known in the art may be contained, including, for example, fluorescent brighteners, antifoamers, lubricants, preservatives, thickeners, antistatic agents, matting agents, water-soluble polyvalent metal salts, acids and bases, pH adjusters such as buffer solutions, antioxidants, surface tension adjusters, specific resistance regulators, anti-corrosion agents, and inorganic pigments.

### [Physical Property Values of Ink]

The ink of the present invention is used to stably produce high precision printing plates via an ink-jet method. Accordingly, there exists a preferable range of physical property values of the ink.

The viscosity of the ink is preferably 1 mPa·s - 15 mPa·s, specifically preferably 2 mPa·s - 8 mPa·s. When the viscosity is at least 1 mPa·s, stable ejection can be realized. When the viscosity is at most 15 mPa·s, satellite occurrence can be prevented and the ink can be ejected at short repetition intervals, resulting in increased production speed.

The surface tension of the ink is preferably 25 mN/m - 50 mN/m, specifically preferably 30 mN/m - 45 mN/m. In the case of at least 25 mN/m, wet spreading of dots having been deposited on a printing plate can be controlled, resulting in enhanced resolution. In the case of at most 50 mN/m, bubbles within the ink-jet recording head can thoroughly escape, whereby excellent ejection stability can be maintained.

### [Production Method of Ink]

The ink of the present invention can be produced via a conventionally known method. In the production process, filtration is preferably carried out. The filtration method is performed, for example, using a metal mesh filter. Further, in combination therewith, using a volume filtration filter made of a resin such as polypropylene, filtration is preferably performed.

Further, the ink of the present invention is preferably degassed. The degassing method includes, for example, a method of degassing by stirring in a vacuum chamber, a method of degassing by sealing after heating the ink, and a method using a degassing module employing hollow fiber. Of these, the method using a degassing module is specifically preferable.

### [Printing Plate Materials]

In printing plate materials used for the plate making method of the present invention, the surface thereof is preferably hydrophilic. As a support used for a printing plate material, any of conventionally known plate materials used for a planographic printing plate can be used with no limitation. There are listed, for example, paper, paper laminated with a plastic (e.g., polyethylene or polypropylene), a metal plate (e.g., aluminum), a plastic film (e.g., cellulose triacetate, cellulose butyrate, cellulose nitrate, polyethylene terephthalate, or polyethylene naphthalate).

Of these, a specifically preferable support includes paper, a polyester film, polyethylene terephthalate, and aluminum plate.

To provide hydrophilic properties on any of such supports, it is preferable to carry out physical treatment such as plasma treatment or corona discharging, or chemical treatment such as coating of a hydrophilic resin or immersion in a surfactant solution individually or in combination. Further, a roughened surface is preferable to easily apply dampening water thereon. The surface roughening method includes a method wherein organic or inorganic fine particles are allowed to adhere to the surface via coating to provide microroughness by the resulting network structure. Another preferable example includes those wherein a waterproof hydrophilic layer is provided on any appropriate support as the surface layer. Such a surface layer includes, for example, the layers composed of an inorganic pigment and a binder described in U.S. Patent No. 3,055,295 and JP-A No. 56-13168; the hydrophilic swollen layers described in JP-A No. 9-80744; and the sol-gel layers composed of titanium oxide, polyvinyl alcohol, and silicic acid described in Japanese Translation of PCT International Application Publication No. 8-507727.

Further, when an aluminum plate, which has widely been employed as a printing plate material, is used, it is preferable to carry out surface roughening treatment; immersion treatment into an aqueous solution of sodium silicate, fluorinated potassium zirconate, or a phosphoric acid salt; or surface treatment such as anodization treatment.

Roughening of the surface of an aluminum plate is carried out via various methods, including, for example, a method of mechanically roughening the surface, a method of electrochemically dissolving and roughening the surface, and a method of chemically dissolving the surface electively. As the mechanical method, usable is a method known in the art such as a ball grinding method, a brush grinding method, a blast grinding method, or a buff grinding method. As the electrochemical surface roughening method, there is a method wherein roughening is carried out in a hydrochloric or nitric acid electrolytic solution with alternating or direct current. Further, prior to surface roughening of the aluminum plate, if desired, in order to remove rolling oil on the surface, degreasing treatment is carried out, for example, using a surfactant, organic solvent, or alkaline aqueous solution.

Furthermore, preferable are those undercoated, after these treatments, with a water-soluble resin, a polymer or copolymer having polyvinyl phosphonic acid or a sulfonic acid group in its side chain, polyacrylic acid, a water-soluble metallic salt (e.g., zinc borate), a yellow dye, or an amine.

### [Ink-jet Recording Method]

In the plate making method of the present invention, using an ink-jet printer loaded with a plate making ink, the ink is ejected from an ink-jet recording head as droplets based on image information, deposited onto a printing plate material, and cured by actinic energy ray radiation, followed by evaporation and drying of the ink solvent to form a printing plate.

The ink-jet recording head used in the plate making method of the present invention may be either an on-demand type or a continuous type. As the ejection method, there can be used any of the ejection methods including an electrical-mechanical conversion type (e.g., a single cavity type, a double cavity type, a vendor type, a piston type, a share mode type, and a shared-wall type) and an electrical-thermal conversion type (e.g., a thermal ink-jet type and a BUBBLE JET (a registered trademark) type).

The amount of ink droplets ejected from the head is preferably 0.5 picoliter - 7 picoliters, specifically preferably 0.8 picoliter - 4 picoliters. When the amount of ink droplets is at least 0.5 picoliter, droplets having been ejected from the head are unaffected by air resistance and then stable jetting performance can be realized, resulting in increased accuracy for a deposition position. When the amount of ink droplets is at most 7 picoliters, a single dot size can be prevented from becoming excessively large, resulting in enhanced resolution for a printing plate.

Further, it is possible that plural droplets are ejected from a single head via specially devised ejection, or are allowed to be deposited after the plural droplets, having continuously been ejected, are united during jetting.

Any types of ink-jet printers are applicable to the present invention. To produce a printing plate resulting in high image quality, a flatbed type or a drum type is preferable. Further, preferable is a method wherein the printer of the present invention is built into a printing machine and then plate making is carried out thereon.

### [Actinic Energy Ray Radiation and Irradiation Method]

The actinic energy ray radiation referred to in the present invention includes, for example, electron beams, UV radiation, α radiation, β radiation, γ radiation, and X-rays. Preferable are electron beams and UV radiation which have gained widespread industrial use, as well as featuring minimal hazard to the human body and easy handling.

When electron beams are employed, the amount of the irradiated electron beams is preferably in the range of 0.1 - 30 Mrad. It is preferable to be at least 0.1 Mrad since adequate irradiation effects can be realized. And it is also preferable to be at most 30 Mrad since adverse effects on the support can be eliminated.

When UV radiation is employed, as a light source, there are used conventionally known ones such as a low pressure, medium pressure, or high pressure mercury lamp featuring an operation pressure of 0.1 kPa - 1 MPa, a metal halide lamp, a xenon lamp having an emission wavelength in the UV range, a cold-cathode tube, a hot-cathode tube, or an LED.

### [Radiation Irradiation Conditions after Ink Deposition]

With regard to irradiation conditions of actinic energy ray radiation, actinic energy ray radiation is preferably irradiated 0.001 - 1.0 second, more preferably 0.001 - 0.5 second after ink deposition. To form highly detailed images, it is specifically crucial that the irradiation timing is as early as possible.

### (Lamp Setting)

As a UV irradiation method of actinic energy ray radiation, a basic method is disclosed in JP-A No. 60-132767. According to this method, a light source is placed on each of both sides of a head unit, and the head and the light sources are scanned via a shuttle method. Irradiation is carried out after the elapse of a predetermined period of time after ink deposition. Then, using another light source independent of driving, curing is completed. U.S. Patent No. 6,145,979 discloses, as irradiation methods, an optical fiber method and a method wherein a collimated light source is directed to a mirror surface placed on the side of a head unit and then UV radiation is irradiated onto a recording section. In the image forming method of the present invention, any of these irradiation methods may be used.

Further, one of the preferred embodiments is also a method wherein irradiation of actinic energy ray radiation is divided into two steps: initially, actinic energy ray radiation is irradiated via the above method 0.001 - 2.0 seconds after ink deposition; and then actinic energy ray radiation is further irradiated.

### EXAMPLES

### Example 1

The present invention will now specifically be described with reference to examples that by no means limit the scope of the present invention. Herein, the expressions "part" and "%" referred to in the examples represent "part by weight" and "weight%", respectively, unless otherwise specified.

### <<Synthesis of Actinic Energy Ray Curable Polymers>>

A reaction container was charged with 56 g of glycidyl methacrylate, 48 g of p-hydroxybenzaldeyde, 2 g of pyridine, and 1 g of N-nitroso-phenylhydroxyamine ammonium salt, followed by being stirred for 8 hours in a water bath of 80 °C.

Subsequently, 45 g of saponified polyvinyl acetate, featuring a polymerization degree of 300 and a saponification rate of 88%, was dispersed in 225 g of ion-exchanged water, and then 4.5 g of phosphoric acid and p-(3-methacryloxy-2-hydroxypropyloxy)benzaldehyde, having been prepared via the above reaction, were added to the resulting solution in such a manner that the modification rate was allowed to be 3 mol% based on polyvinyl alcohol, followed by being stirred at 90 °C for 6 hours. The thus-prepared solution was cooled to room temperature, and 30 g of a basic ion-exchange resin was added, followed by being stirred for 1 hour. Then, the ion-exchange resin was filtered, and IRUGACURE 2959 (produced by Ciba Specialty Chemicals, Ltd.) was blended, as a photopolymerization initiator, at a ratio of 0.1 g based on 100 g of a 15% aqueous solution, followed by dilution with ion-exchanged water to give a 10% polymer 1 aqueous solution.

Subsequently, the 10% aqueous solutions of polymers 2 - 12, listed in Table 1, were prepared in such a manner that in preparation of the above polymer 1 aqueous solution, as appropriate, the polymerization degree and the saponification degree of the saponified polyvinyl acetate were changed and the charged amount of p-(3-methacryloxy-2-hydroxypropyloxy)benzaldehyde was changed to adjust the modification rate.

### [Preparation of Image Forming Ink]

### (Preparation of Ink 1)

| | |
|---|---|
| 10% polymer 1 aqueous solution | 30 parts |
| Glycerin | 15 parts |
| Diethylene glycol monobutyl ether | 2 parts |
| OLFIN E1010 (produced by Nissin Chemical Industry Co., Ltd.) | 0.2 part |

Ion-exchanged water was added to the above to give a total amount of 100 parts, followed by stirring for mixing.

Then, filtration was carried out using a #3500 mesh metal filter, followed by degassing with a hollow fiber module to prepare Ink 1.

### (Preparation of Ink 2)

| | |
|---|---|
| 10% polymer 1 aqueous solution | 30 parts |
| Cyan pigment dispersion: Cab-o-jet250C | 6 parts |
| Glycerin | 15 parts |
| Diethylene glycol monobutyl ether | 2 parts |
| OLFIN E1010 (produced by Nissin Chemical Industry Co., Ltd.) | 0.2 part |

Ion-exchanged water was added to the above to give a total amount of 100 parts, followed by filtration and degassing in the same manner as for Ink 1 to prepare Ink 2.

### (Preparation of Inks 3 - 15)

Inks 3 - 15 were prepared in the same manner as in preparation of Ink 2 except that Polymer 1 and the ink composition contained in the polymer 1 aqueous solution were changed to each of the compounds listed in Table 1.

### (Ink 16)

| | |
|---|---|
| Polymerizable compound A | 15 parts |
| Photopolymerization initiator A | 1 part |
| Cyan pigment dispersion: Cab-o-jet250C | 6 parts |
| Glycerin | 15 parts |
| Diethylene glycol monobutyl ether | 2 parts |
| Triethanolamine | 1 part |
| OLFIN E1010 (produced by Nissin Chemical Industry Co., Ltd.) | 0.2 part |

Ion-exchanged water was added to the above to give a total amount of 100 parts, followed by filtration and degassing in the same manner as for Ink 1 to prepare Ink 16.

### Polymerizable compound A

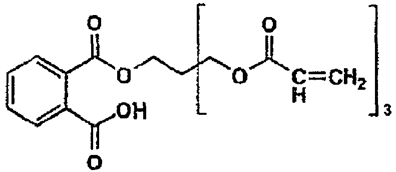

### Photopolymerization initiator A

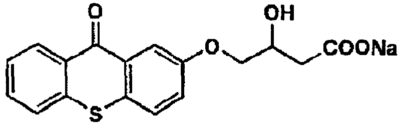

### (Ink 17)

| | |
|---|---|
| Pentaerythritol tetraacrylate | 30 parts |
| Diisopropylthioxanthone | 2 parts |
| Diethylamino isoamyl benzoate | 1 part |
| Silicone varnish | 20 parts |
| Nigrosine black | 1 part |
| Xylene | 80 parts |

The above was mixed and then Ink 17 was prepared in the same manner as for Ink 1.

Of the above inks prepared, the constitutions of Inks 1 - 16 are listed in Table 1. Herein, the detail of each of the items such as the additives with the abbreviated expressions listed in Table 1 is as follows:
*1: the content rate (%) of a polymer in the ink
Gly: glycerin
PG: propylene glycol
DEGBE: diethylene glycol monobutyl ether
CAB: Cab-o-jet250C (a cyan pigment)
E1010: OLFIN E1010 (produced by Nissin Chemical Industry Co., Ltd.)

**Table 1**

| Ink No. | Polymer | | | | | Photopolymerization Initiator (%) | Ink Solvent | | | | Pigment | Surfactant | Remarks |
|---|---|---|---|---|---|---|---|---|---|---|---|---|---|
| | No. | Saponification Rate (%) | Polymerization Degree | Modification Rate (mol %) | *1 (%) | | Water (%) | Gly (%) | PG (%) | DEGBE (%) | CAB (%) | E1010 (%) | |
| 1 | 1 | 88 | 300 | 3.0 | 3.0 | 0.02 | 79.78 | 15.0 | - | 2.0 | - | 0.2 | Inv. |
| 2 | 1 | 88 | 300 | 3.0 | 3.0 | 0.02 | 79.78 | 15.0 | - | 2.0 | 6.0 | 0.2 | Inv. |
| 3 | 2 | 88 | 500 | 3.0 | 2.0 | 0.02 | 80.98 | 15.0 | - | 2.0 | 6.0 | - | Inv. |
| 4 | 3 | 88 | 5000 | 3.0 | 0.9 | 0.01 | 77.89 | - | 12.0 | 3.0 | 6.0 | 0.2 | Comp. |
| 5 | 4 | 88 | 150 | 3.0 | 4.8 | 0.04 | 76.96 | 10.0 | - | 2.0 | 6.0 | 0.2 | Comp. |
| 6 | 5 | 88 | 600 | 1.0 | 2.0 | 0.02 | 77.78 | 12.0 | - | 2.0 | 6.0 | 0.2 | Inv. |
| 7 | 6 | 100 | 300 | 3.0 | 3.0 | 0.02 | 73.78 | 16.0 | - | 1.0 | 6.0 | 0.2 | Inv. |
| 8 | 7 | 60 | 300 | 2.0 | 3.0 | 0.02 | 75.78 | 7.0 | - | 8.0 | 6.0 | 0.2 | Inv. |
| 9 | 8 | 88 | 6000 | 3.0 | 0.7 | 0.01 | 86.09 | - | 5.0 | 2.0 | 6.0 | 0.2 | Comp. |
| 10 | 9 | 88 | 250 | 3.0 | 6.0 | 0.04 | 79.76 | - | 5.0 | 3.0 | 6.0 | 0.2 | Comp. |
| 11 | 1 | 88 | 300 | 3.0 | 3.0 | 0.02 | 48.78 | - | 40.0 | 2.0 | 6.0 | 0.2 | Inv. |
| 12 | 1 | 88 | 300 | 3.0 | 3.0 | 0.02 | 38.78 | - | 50.0 | 2.0 | 6.0 | 0.2 | Inv. |
| 13 | 10 | 88 | 600 | 3.0 | 0.6 | 0.02 | 77.78 | 12.0 | - | 2.0 | 6.0 | 0.2 | Comp. |
| 14 | 11 | 88 | 300 | 0.6 | 3.0 | 0.02 | 79.78 | 15.0 | - | 2.0 | 6.0 | 0.2 | Inv. |
| 15 | 12 | 88 | 300 | 6.2 | 3.0 | 0.02 | 75.78 | 15.0 | - | 2.0 | 6.0 | 0.2 | Inv. |
| 16 | A | - | - | - | 15.0 | 1.0 | 62.85 | 13.0 | - | 2.0 | 6.0 | 0.15 | Comp. |

| | | | | | | | | | | | | | |
|---|---|---|---|---|---|---|---|---|---|---|---|---|---|
| Inv.: Inventive, Comp.: Comparative | | | | | | | | | | | | | |

### <<Production of Printing Plates»

### (Ink-jet Printer)

The ink-jet printer shown in FIG. 1 was employed. The printer is a flatbed-type ink-jet printer wherein 8 piezo-type ink-jet heads, with 512 nozzles each, featuring a nozzle diameter of 20 µm and a nozzle resolution of 300 dpi ("dpi" referred to in the present invention represents the number of dots per 2.54 cm), is mounted on carriage 1, and UV irradiation source 2 is placed on each of both sides of carriage 1. Carriage 1 moves in the X direction of FIG. 1, and moves in the Y direction in such a manner that plate material 4 is allowed to move by conveyance roller 3 on the flatbed.

### (Production of Printing Plates)

An image having a resolution of 2400 dpi x 2400 dpi was formed on a grained aluminum substrate serving as a plate material with a droplet amount of 1 picoliter for each ink ejected from the printer of FIG. 1. For overall evaluation, the image was prepared by combination of a solid image of 10 cm x 10 cm, a fine line image, 3-point - 10-point Mincho typeface character images, and an image composed of a natural image (a photograph).

The ink was hardened via irradiation of a metal halide lamp (MAL 400NL with a supply power of 3 kW·hr, produced by Japan Storage Battery Co., Ltd.) placed on each of both sides of the carriage under a condition of 120 W/cm.

Since each of the inks differs in viscosity, a voltage applied to the piezo elements of the printer was controlled so as for the droplet amount of each ink to be 1 picoliter.

### <<Evaluation of Printing Plate Images>>

### (Evaluation of Adhesion)

Based on JIS K5400, there were prepared a sample wherein 11 cut lines were made on a printed surface vertically and horizontally in a grid pattern at 1 mm regular intervals and also an undamaged sample. A cellophane tape was allowed to adhere to each printed surface. Then, the state immediately after rapid peeling at an angle of 90 ° was visually observed. Adhesion was evaluated based on the following criteria:
A: No peeling-off of a printed image is noted even in the grid test.
B: Peeling-off is noted to some extent in the grid test, but no peeling-off is noted with respect to a sample with an undamaged printed surface.
C: Peeling-off is noted even with respect to a sample with an undamaged printed surface.

### (Evaluation of Printing Durability)

A printing plate produced was mounted on a printing machine, and printing was carried out on coated paper (OK KINFUJI, produced by Oji Paper Co., Ltd.). Lack in the fine line portion and lack or crush of the 3-point character on the thus-printed paper were observed using a magnifier. Based on the following criteria, printing durability was evaluated.
A: No lack or crush is noted even with respect to the 10,000th sheet of printed matter.
B: Slight lack is noted with respect to the 10,000th sheet of printed matter, but no lack or crush is noted with respect to the 5,000th sheet of printed matter.
C: Lack or crush is noted with respect to the 5,000th sheet of printed matter.
D: Lack or crush is noted with respect to the 1,000th sheet of printed matter.

### (In-plane Printing Density Stability)

An A3 printing plate was produced to print a 15% dot patch of a size of 3 cm x 3 cm placed on each of the four corners of the printing plate, and mounted on a printing machine to carry out printing on coated paper (OK KINFUJI, produced by Oji Paper Co., Ltd.). The densities of the 4 locations on the printed paper were determined using X-RITE528 (produced by X-Rite, Inc.). Based on the following criteria, printing density stability was evaluated.
A: Density variation of the 4 locations is less than 3%.
B: Density variation of the 4 locations is 3% - less than 10%.
C: Density variation of the 4 locations is at least 10%.

### (Evaluation of Dot Gain)

An A3 printing plate was produced to print a 15% dot patch of a size of 3 cm x 3 cm placed on each of the four corners of the printing plate, and mounted on a printing machine to carry out printing on coated paper (OK KINFUJI, produced by Oji Paper Co., Ltd.).

The dot% of the patch printed was measured using X-RITE528 (produced by X-Rite, Inc.). Based on the following criteria, dot gain was evaluated.
A: The dot% was 15% ± 3%.
B: The dot% was 15% ± 5%.
C: The dot% exceeded 15% ± 5%.

### (Evaluation of Ink Viscosity Suitability)

The ink viscosity at 25 °C was determined using VM-1AL (CBC Materials Co., Ltd.) as an oscillation viscometer. Based on the following criteria, ink viscosity suitability was evaluated.
A: 2 mPa·s - less than 8 mPa·s
B: Less than 2 mPa·s, or 8 mPa·s - less than 15 mPa·s
C: At least 15 mPa·s

The results obtained above are listed in Table 2.

**Table 2**

| Ink No. | Adhesion | Dot Gain | Printing Density Stability | Printing Durability | Ink Viscosity Suitability | Remarks |
|---|---|---|---|---|---|---|
| 1 | A | A | A | A | A | Inv. |
| 2 | A | A | A | A | A | Inv. |
| 3 | A | A | A | A | A | Inv. |
| 4 | C | B | C | B | C | Comp. |
| 5 | C | B | A | C | A | Comp. |
| 6 | A | A | A | B | A | Inv. |
| 7 | B | A | A | B | A | Inv. |
| 8 | B | A | B | B | A | Inv. |
| 9 | C | A | B | C | C | Comp. |
| 10 | A | B | C | B | A | Comp. |
| 11 | B | A | B | C | A | Inv. |
| 12 | B | A | B | C | A | Inv. |
| 13 | C | B | C | D | A | Comp. |
| 14 | A | A | B | B | A | Inv. |
| 15 | A | A | B | C | A | Inv. |
| 16 | B | C | C | B | C | Comp. |
| 17 | A | C | C | B | C | Comp. |

| | | | | | | |
|---|---|---|---|---|---|---|
| Inv.: Inventive, Comp.: Comparative | | | | | | |

The results shown in Table 2 clearly show that the plate making method of the present invention employing a plate making ink containing a polymer according to the present invention in the range of 0.8 weight% - 5.0 weight% based on the total weight of the ink is superior each in printing plate adhesion, printing durability, printing density stability, and dot gain, and further the ink exhibits appropriate viscosity characteristics, compared to the comparative examples.

### Example 2

### <<Synthesis of Polymers>>

### [Preparation of Polymer A]

A reaction container was charged with 56 g of glycidyl methacrylate, 48 g of p-hydroxybenzaldeyde, 2 g of pyridine, and 1 g of N-nitroso-phenylhydroxyamine ammonium salt, followed by being stirred for 8 hours in a water bath of 80 °C.

Subsequently, 45 g of saponified polyvinyl acetate, featuring a polymerization degree of 300 and a saponification rate of 88%, was dispersed in 225 g of ion-exchanged water, and then 4.5 g of phosphoric acid and p-(3-methacryloxy-2-hydroxypropyloxy)benzaldehyde, having been prepared via the above reaction, were added to the resulting solution in such a manner that the modification rate was allowed to be 3 mol% based on polyvinyl alcohol, followed by being stirred at 90 °C for 6 hours. The thus-prepared solution was cooled to room temperature, and 30 g of a basic ion-exchange resin was added, followed by being stirred for 1 hour. Then, the ion-exchange resin was filtered, and IRUGACURE 2959 (produced by Ciba Specialty Chemicals, Ltd.) was blended, as a photopolymerization initiator, at a ratio of 0.1 g based on 100 g of a 15% aqueous solution, followed by dilution with ion-exchanged water to give a 10% polymer Al aqueous solution.

Subsequently, in preparation of above Polymer A1 aqueous solution, as appropriate, the polymerization degree and the saponification degree of the saponified polyvinyl acetate were changed, and then the charged amount of p-(3-methacryloxy-2-hydroxypropyloxy)benzaldehyde was changed to adjust the modification rate. Thus, 10% aqueous solutions of polymer A2 - A9, featuring the characteristics listed in Table 4, were prepared.

### [Polymer B: Preparation of Alkali-soluble Resin Aqueous Solution]

### (Preparation of Polymer B1 Aqueous Solution)

Ten parts of a resin listed in Table 3 was added to 70 parts of ion-exchanged water while stirring, and then mixed, and during monitoring with a pH meter, potassium hydroxide was dripped until the point of neutralization. The resulting solution was finished to a total amount of 100 parts by addition of ion-exchanged water to prepare a 10% polymer B1 aqueous solution.

### (Preparation of Polymer B2 Aqueous Solution - Polymer B10 Aqueous Solution)

There were prepared 10% polymer B2 aqueous solution - 10% polymer B10 aqueous solution in the same manner as in preparation of the above polymer B1 aqueous solution except that the combination of the resin and the alkaline agent was changed to those listed in Table 1.

**Table 3**

| Polymer B No. | Resin Composition | | | | Alkaline Agent |
|---|---|---|---|---|---|
| | Name | Molecular Weight | Acid Value | Amount Added | |
| B1 | styrene-acrylic acid copolymer | 12500 | 213 | 10 parts | potassium hydroxide |
| B2 | styrene-maleic acid copolymer | 12000 | 190 | 10 parts | sodium hydroxide |
| B3 | styrene-acrylic acid copolymer | 25000 | 200 | 10 parts | ammonia |
| B4 | styrene-acrylic acid copolymer | 12500 | 213 | 10 parts | monoethanolamine |
| B5 | styrene-acrylic acid copolymer | 12500 | 213 | 10 parts | dimethylethanolamine |
| B6 | styrene-acrylic acid copolymer | 4900 | 215 | 10 parts | monoethanolamine |
| B7 | styrene-acrylic acid copolymer | 1700 | 238 | 10 parts | ammonia |
| B8 | styrene-maleic acid copolymer | 12000 | 190 | 10 parts | dimethylethanolamine |
| B9 | acrylic acid copolymer | 8000 | 220 | 10 parts | dimethylethanolamine |
| B10 | acrylic acid copolymer | 15000 | 200 | 10 parts | dimethylethanolamine |

### <<Preparation of Plate Making Ink>>

### (Preparation of Ink 21)

| | |
|---|---|
| 10% polymer A1 aqueous solution | 30 parts |
| 10% polymer B5 aqueous solution | 30 parts |
| Diethylene glycol | 13 parts |
| Diethylene glycol monobutyl ether | 2 parts |
| OLFIN E1010 (produced by Nissin Chemical Industry Co., Ltd.) | 0.2 part |

Ion-exchanged water was added to the above to give a total amount of 100 parts, followed by stirring for mixing.

Then, filtration was carried out using a #3500 mesh metal filter, followed by degassing with a hollow fiber module to prepare Ink 21.

### (Preparation of Ink 22)

| | |
|---|---|
| 10% polymer A1 aqueous solution | 30 parts |
| 10% polymer B5 aqueous solution | 30 parts |
| Cyan pigment dispersion: Cab-o-jet250C | 6 parts |
| Diethylene glycol | 13 parts |
| Diethylene glycol monobutyl ether | 2 parts |
| OLFIN E1010 (produced by Nissin Chemical Industry Co., Ltd.) | 0.2 part |

Ion-exchanged water was added to the above to give a total amount of 100 parts, followed by filtration and degassing in the same manner as for ink 21 to prepare Ink 22.

### (Preparation of Inks 23 - 42)

Inks 23 - 42 were prepared in the same manner as in preparation of above Ink 22 except that the polymer A aqueous solution, the polymer B aqueous solution, and the ink composition were changed to each of the compounds listed in Table 4.

### (Preparation of Ink 43)

| | |
|---|---|
| Polymerizable compound A (described above) | 15 parts |
| Photopolymerization initiator A (described above) | 1 part |
| 10% polymer B5 aqueous solution | 30 parts |
| Cyan pigment dispersion Cab-o-jet250C | 6 parts |
| Diethylene glycol | 13 parts |
| Diethylene glycol monobutyl ether | 2 parts |
| Triethanolamine | 1 part |
| OLFIN E1010 (produced by Nissin Chemical Industry Co., Ltd.) | 0.2 part |

Ion-exchanged water was added to the above to give a total amount of 100 parts, followed by filtration and degassing in the same manner as for ink 21 to prepare Ink 43.

Of the inks prepared above, the constitutions of Inks 21 - 42 except Ink 45 are listed in Table 4. Herein, the detail of each of the items such as the additives with the abbreviated expressions listed in Table 4 is as follows:
*1: the content rate (%) of Polymer A in the ink
*2: the content rate (%) of Polymer B in the ink DEG: diethylene glycol
PG: propylene glycol
DEGBE: diethylene glycol monobutyl ether
CAB: Cab-o-jet250C (a cyan pigment)
E1010: OLFIN E1010 (produced by Nissin Chemical Industry Co., Ltd.)

**Table 4**

| Ink No. | Polymer A | | | | | Photopolymer ization Initiator (%) | Polymer B | | Ink Solvent | | | Pigment | Surfactant | Remarks |
|---|---|---|---|---|---|---|---|---|---|---|---|---|---|---|
| | No. | Saponification Rate (%) | Polymerization Degree | Modification Rate (mol%) | *1 (%) | | No. | *2 (%) | DEG (%) | PG (%) | DEGBE (%) | CAB (%) | E1010 (%) | |
| 21 | A1 | 88 | 300 | 3.0 | 3.0 | 0.02 | B5 | 3.0 | 13.0 | - | 2.0 | - | 0.2 | Ink. |
| 22 | A1 | 88 | 300 | 3.0 | 3.0 | 0.02 | B5 | 3.0 | 13.0 | - | 2.0 | 6.0 | 0.2 | Inv. |
| 23 | A2 | 60 | 300 | 2.0 | 2.0 | 0.02 | - | - | 6.5 | - | 8.0 | 6.0 | 0.2 | Inv. |
| 24 | A2 | 60 | 300 | 2.0 | 2.0 | 0.02 | B5 | 3.0 | 6.5 | - | 8.0 | 6.0 | 0.2 | Inv. |
| 25 | A3 | 88 | 500 | 3.0 | 2.0 | 0.02 | B5 | 3.0 | 12.0 | - | 2.0 | 6.0 | - | Inv. |
| 26 | A6 | 88 | 600 | 1.0 | 2.0 | 0.02 | B5 | 3.0 | 11.0 | - | 2.0 | 6.0 | 0.2 | Inv. |
| 27 | A7 | 100 | 300 | 3.0 | 3.0 | 0.02 | B5 | 3.0 | 14.0 | - | 1.0 | 6.0 | 0.2 | Inv. |
| 28 | A2 | 60 | 300 | 2.0 | 3.0 | 0.02 | B5 | 3.0 | 6.0 | - | 8.0 | 6.0 | 0.2 | Inv. |
| 29 | A1 | 88 | 300 | 3.0 | 3.0 | 0.02 | B5 | 3.0 | - | 39.5 | 2.0 | 4.0 | 0.2 | Inv. |
| 30 | A1 | 88 | 300 | 3.0 | 3.0 | 0.02 | B5 | 3.0 | - | 49.0 | 2.0 | 4.0 | 0.2 | Inv. |
| 31 | A1 | 88 | 300 | 3.0 | 3.0 | 0.02 | B1 | 0.05 | 14.0 | - | 2.0 | 4.0 | 0.2 | Inv. |
| 32 | A1 | 88 | 300 | 3.0 | 3.0 | 0.02 | B2 | 4.0 | 13.0 | - | 2.0 | 4.0 | 0.2 | Inv. |
| 33 | A1 | 88 | 300 | 3.0 | 3.0 | 0.02 | B3 | 6.0 | 12.5 | - | 2.0 | 4.0 | 0.2 | Inv. |
| 34 | A1 | 88 | 300 | 3.0 | 3.0 | 0.02 | B4 | 2.0 | 16.0 | - | 2.0 | 4.0 | 0.2 | Inv. |
| 35 | A1 | 88 | 300 | 3.0 | 3.0 | 0.02 | B6 | 6.0 | 11.0 | - | 2.0 | 4.0 | 0.2 | Inv. |
| 36 | A1 | 8B | 300 | 3.0 | 3.0 | 0.02 | B7 | 8.0 | 14.0 | - | 2.0 | 4.0 | 0.2 | Inv. |
| 37 | A1 | 88 | 300 | 3.0 | 3.0 | 0.02 | B7 | 11.0 | 14.0 | - | 2.0 | 4.0 | 0.2 | Inv. |
| 38 | A1 | 88 | 300 | 3.0 | 3.0 | 0.02 | B8 | 0.15 | 18.0 | - | 1.0 | 4.0 | 0.2 | Inv. |
| 39 | A1 | 88 | 300 | 3.0 | 3.0 | 0.02 | B9 | 5.0 | 14.0 | - | 2.0 | 4.0 | 0.2 | Inv. |
| 40 | A1 | 88 | 300 | 3.0 | 3.0 | 0.02 | B10 | 3.0 | 15.0 | - | 2.0 | 4.0 | 0.2 | Inv. |
| 41 | A8 | 88 | 6000 | 3.0 | 0.7 | 0.01 | B5 | 3.0 | - | 5.0 | 2.0 | 5.0 | 0.2 | Comp. |
| 42 | A9 | 88 | 250 | 3.0 | 6.0 | 0.04 | B5 | 3.0 | - | 5.0 | 3.0 | 5.0 | 0.2 | Comp. |

| | | | | | | | | | | | | | | |
|---|---|---|---|---|---|---|---|---|---|---|---|---|---|---|
| Inv.: Inventive, Comp.: Comparative | | | | | | | | | | | | | | |

### «Production of Printing Plates»

Printing plates were produced using each of the inks in the same manner as described in Example 1.

### «Evaluation of Printing Plate Images»

In the same manner as described in Example 1, printing durability, dot gain, and ink viscosity suitability were evaluated. Further, water-rubbing resistance and ink receptivity were evaluated based on the following methods.

### (Evaluation of Water-rubbing Resistance)

An entire printing plate was strongly rubbed with a sponge soaked in a 1% solution of living care detergent MAMALEMON (produced by Lion Corp.). After rubbing, the state of the printing plate image was visually observed. Water-rubbing resistance was evaluated based on the following criteria.
A: An entire printing plate image was not removed at all even via rubbing of 100 times.
B: An entire printing plate image was not removed at all even via rubbing of 30 times.
C: Lack in a part of the fine lines was noted at the time of rubbing of 30 times.
D: The 3-point character became illegible at the time of rubbing of 30 times.

### (Evaluation of Ink receptivity)

A produced printing plate was mounted on a printing machine to carry out printing on coated paper (OK KINFUJI, produced by Oji Paper Co., Ltd.). The state of a printed solid image was visually observed. Ink receptivity were evaluated based on the following criteria.
A: The density of a printed solid portion is high and excellent, and no unevenness is noted in the solid image portion.
B: The density of a printed solid portion is high, and slight unevenness is noted in the solid image portion.
C: The density of a printed solid portion is slightly low, and unevenness is noted.
D: The density of a printed solid portion is low, and marked unevenness is noted.

The results obtained above are listed in Table 5.

**Table 5**

| Ink No. | Water-rubbing Resistance | Ink receptivity | Dot Gain | Printing Durability | Ink Viscosity Suitability | Remarks |
|---|---|---|---|---|---|---|
| 21 | A | A | A | A | A | Inv. |
| 22 | A | B | A | A | A | Inv. |
| 23 | C | C | A | C | A | Inv. |
| 24 | A | A | A | A | A | Inv. |
| 25 | A | A | A | A | A | Inv. |
| 26 | B | B | A | A | A | Inv. |
| 27 | B | B | A | B | A | Inv. |
| 28 | B | A | A | A | A | Inv. |
| 29 | A | A | A | A | A | Inv. |
| 30 | A | A | A | A | A | Inv. |
| 31 | B | B | A | B | A | Inv. |
| 32 | B | B | A | B | A | Inv. |
| 33 | A | A | A | A | B | Inv. |
| 34 | A | A | A | A | A | Inv. |
| 35 | B | A | A | A | A | Inv. |
| 36 | C | B | A | C | A | Inv. |
| 37 | B | B | B | C | B | Inv. |
| 38 | A | A | A | A | A | Inv. |
| 39 | B | A | A | A | A | Inv. |
| 40 | A | A | A | A | A | Inv. |
| 41 | D | C | B | C | B | Comp. |
| 42 | B | C | C | B | A | Comp. |
| 43 | B | B | C | B | C | Comp. |

| | | | | | | |
|---|---|---|---|---|---|---|
| Inv.: Inventive, Comp.: Comparative | | | | | | |

The results shown in Table 5 clearly show that the plate making method of the present invention employing a plate making ink containing a polymer and also an alkali-soluble polymer according to the present invention in an amount specified by the present invention is superior each in water-rubbing resistance, ink receptivity, printing durability, and dot gain, compared to the comparative examples.

### Example 3

### <<Synthesis of Polymers>>

A reaction container was charged with 56 g of glycidyl methacrylate, 48 g of p-hydroxybenzaldeyde, 2 g of pyridine, and 1 g of N-nitroso-phenylhydroxyamine ammonium salt, followed by being stirred for 8 hours in a water bath of 80 °C.

Subsequently, 45 g of saponified polyvinyl acetate, featuring a polymerization degree of 300 and a saponification rate of 88%, was dispersed in 225 g of ion-exchanged water, and then 4.5 g of phosphoric acid and p-(3-methacryloxy-2-hydroxypropyloxy)benzaldehyde, having been prepared via the above reaction, were added to the resulting solution in such a manner that the modification rate was allowed to be 3 mol% based on polyvinyl alcohol, followed by being stirred at 90 °C for 6 hours. The thus-prepared solution was cooled to room temperature, and 30 g of a basic ion-exchange resin was added, followed by being stirred for 1 hour. Then, the ion-exchange resin was filtered, and IRUGACURE 2959 (produced by Ciba Specialty Chemicals, Ltd.) was blended, as a photopolymerization initiator, at a ratio of 0.1 g based on 100 g of a 15% aqueous solution, followed by dilution with ion-exchanged water to give a 10% polymer 21 aqueous solution.

Subsequently, the 10% aqueous solutions of polymers 22 - 31, listed in Table 7, were prepared in such a manner that in preparation of the above polymer 1 aqueous solution, as appropriate, the polymerization degree and the saponification degree of the saponified polyvinyl acetate were changed and the charged amount of p-(3-methacryloxy-2-hydroxypropyloxy)benzaldehyde was changed to adjust the modification rate.

### [Preparation of Plate Making Ink]

### (Preparation of Ink 61)

| | |
|---|---|
| 10% polymer 1 aqueous solution | 30 parts |
| JONCRYL 734 (produced by Johnson Polymer, Inc.) | 4.76 parts |
| Ethylene glycol | 13 parts |
| Diethylene glycol monobutyl ether | 2 parts |
| OLFIN E1010 (produced by Nissin Chemical Industry Co., Ltd.) | 0.15 part |

Ion-exchanged water was added to the above to give a total amount of 100 parts, followed by stirring for mixing.

Then, filtration was carried out using a #3500 mesh metal filter, followed by degassing with a hollow fiber module to prepare Ink 61.

### (Preparation of Ink 62)

| | |
|---|---|
| 10% polymer 1 aqueous solution | 30 parts |
| JONCRYL 734 (produced by Johnson Polymer, Inc.) | 4.76 parts |
| Cyan pigment dispersion: Cab-o-jet250C | 6 parts |
| Ethylene glycol | 13 parts |
| Diethylene glycol monobutyl ether | 2 parts |
| OLFIN E1010 (produced by Nissin Chemical Industry Co., Ltd.) | 0.15 part |

Ion-exchanged water was added to the above to give a total amount of 100 parts, followed by filtration and degassing in the same manner as for Ink 61 to prepare Ink 62.

### (Preparation of Inks 63 - 88)

Inks 63 - 88 were prepared in the same manner as in preparation of above Ink 62 except that the polymer, the resin fine particle, and the ink composition were changed to each of the compounds listed in Table 7.

### (Preparation of Ink 89)

### Polymerizable compound A (described above)

| | |
|---|---|
| Photopolymerization initiator A (described above) | 1 part |
| JONCRYL 734 (produced by Johnson Polymer, Inc.) | 4.8 parts |
| Cyan pigment dispersion: Cab-o-jet250C | 6 parts |
| Ethylene glycol | 13 parts |
| Diethylene glycol monobutyl ether | 2 parts |
| Triethanolamine | 1 part |
| OLFIN E1010 (produced by Nissin Chemical Industry Co., Ltd.) | 0.15 part |

Ion-exchanged water was added to the above to give a total amount of 100 parts, followed by filtration and degassing in the same manner as for ink 1 to prepare Ink 89.

Each of the resin fine particles used in preparation of above Inks 61 - 89 is shown in detail in Table 6.

Herein, with regard to the resin fine particles listed in Table 6, the JONCRYL series are produced by Johnson Polymer, Inc. The SUPERFLEX series and the SX series are produced by Dai-ichi Kogyo Seiyaku Co., Ltd. and Zeon Corp., respectively.

**Table 6**

| Resin Fine Particle No. | Resin Fine Particle | | | | |
|---|---|---|---|---|---|
| | Name | Tg (°C) | Acid Value | Average Particle Diameter (nm) | Solid Concentration (%) |
| 1 | JONCRYL 711 | 0 | 100 | 100 | 48 |
| 2 | JONCRYL 7001 | 12 | 87 | 80 | 42 |
| 3 | JONCRYL 450 | 16 | 100 | 60 | 42 |
| 4 | JONCRYL 734 | 30 | 87 | 80 | 42 |
| 5 | JONCRYL 775 | 37 | 55 | 80 | 45 |
| 6 | JONCRYL 352 | 56 | 51 | 100 | 45 |
| 7 | JONCRYL 790 | 30 | 30 | 200 | 47 |
| 8 | JONCRYL 780 | 46 | 46 | 100 | 48 |
| 9 | SUPERFLEX 110 | 48 | - | 90 | 30 |
| 10 | SUPERFLEX 300 | -42 | - | 70 | 30 |
| 11 | SUPERFLEX 410 | -16 | - | 200 | 40 |
| 12 | SUPERFLEX 420 | -10 | - | 10 | 32 |
| 13 | SUPERFLEX 130 | 101 | - | 20 | 35 |
| 14 | SX1706 | 0 | - | 100 | 48 |
| 15 | SX1105 | 0 | - | 100 | 45 |

Herein, the detail of each of the items such as the additives with the abbreviated expressions listed in Table 7 is as follows:
*1: the solid content rate (%) of a polymer in the ink
*2: the solid content rate (%) of a resin fine particle in the ink
EG: ethylene glycol
PG: propylene glycol
DEGBE: diethylene glycol monobutyl ether
CAB: Cab-o-jet250C (a cyan pigment)
E1010: OLFIN E1010 (produced by Nissin Chemical Industry Co., Ltd.)

**Table 7**

| Ink No. | Polymer | | | | | ** | Resin Fine Particle | | Ink Solvent | | | Pigment | Surfactant | Remarks |
|---|---|---|---|---|---|---|---|---|---|---|---|---|---|---|
| | No. | Saponification Rate (%) | Polymerization Degree | Modification Rate (mol %) | *1 (%) | | No. | *2 | EG (%) | PG (%) | DEGBE (%) | CAB (%) | E1010 (%) | |
| 61 | 21 | 88 | 300 | 3.0 | 3.0 | 0.02 | 4 | 2.0 | 13.0 | - | 2.0 | - | 0.15 | Inv. |
| 62 | 21 | 88 | 300 | 3.0 | 3.0 | 0.02 | 4 | 2.0 | 13.0 | - | 2.0 | 6.0 | 0.15 | Inv. |
| 63 | 22 | 60 | 300 | 2.0 | 2.0 | 0.02 | - | - | 6.5 | - | 8.0 | 6.0 | 0.15 | Inv. |
| 64 | 22 | 60 | 300 | 2.0 | 2.0 | 0.02 | 4 | 2.0 | 6.3 | - | 8.0 | 6.0 | 0.15 | Inv. |
| 65 | 23 | 88 | 500 | 3.0 | 2.0 | 0.02 | 4 | 2.0 | 12.5 | - | 2.0 | 6.0 | - | Inv. |
| 66 | 26 | 88 | 600 | 1.0 | 2.0 | 0.02 | 4 | 2.0 | 11.5 | - | 2.0 | 6.0 | 0.15 | Inv. |
| 67 | 27 | 100 | 300 | 3.0 | 3,0 | 0.02 | 4 | 2.0 | 13.0 | - | 1.0 | 6.0 | 0.15 | Inv. |
| 68 | 22 | 60 | 300 | 2.0 | 3.0 | 0.02 | 4 | 2.0 | 6.5 | - | 8.0 | 6.0 | 0.15 | Inv. |
| 69 | 21 | 88 | 300 | 3.0 | 3.0 | 0.20 | 4 | 2.0 | - | 39.5. | 2.0 | 4.0 | 0.15 | Inv. |
| 70 | 21 | 88 | 300 | 3.0 | 3.0 | 0.02 | 4 | 2.0 | - | 49.0 | 2.0 | 4.0 | 0.15 | Inv. |
| 71 | 21 | 88 | 300 | 3.0 | 3.0 | 0.02 | 1 | 1.0 | 13.0 | - | 1.5 | 4.0 | 0.15 | Inv. |
| 72 | 21 | 88 | 300 | 3.0 | 3.0 | 0.02 | 2 | 8.0 | 13.5 | - | 1.5 | 4.0 | 0.15 | Inv. |
| 73 | 21 | 88 | 300 | 3.0 | 3.0 | 0.02 | 3 | 6.0 | 12.0 | - | 1.5 | 4.0 | 0.15 | Inv. |
| 74 | 21 | 88 | 300 | 3.0 | 3.0 | 0.02 | 5 | 2.0 | 14.0 | - | 1.5 | 4.0 | 0.15 | Inv. |
| 75 | 21 | 88 | 300 | 3.0 | 3.0 | 0.02 | 6 | 1.5 | 11.5 | - | 1.5 | 4.0 | 0.15 | Inv. |
| 76 | 21 | 88 | 300 | 3.0 | 3.0 | 0.02 | 7 | 3.0 | 13.0 | - | 2.0 | 4.0 | 0.15 | Inv. |
| 77 | 21 | 88 | 300 | 3.0 | 3.0 | 0.02 | 8 | 0.15 | 16.0 | - | 1.0 | 4.0 | 0.15 | Inv. |
| 78 | 21 | 88 | 300 | 3.0 | 3.0 | 0.02 | 9 | 0.05 | 16.0 | - | 1.5 | 4.0 | 0.15 | Inv. |
| 79 | 21 | 88 | 300 | 3.0 | 3.0 | 0.02 | 10 | 3.0 | 14.0 | - | 1.5 | 4.0 | 0.15 | Inv. |
| 80 | 21 | 88 | 300 | 3.0 | 3.0 | 0.02 | 11 | 3.0 | 15.5 | - | 1.5 | 4.0 | 0.15 | Inv. |
| 81 | 21 | 88 | 300 | 3.0 | 3.0 | 0.02 | 12 | 8.0 | 13.0 | - | 1.5 | 4.0 | 0.15 | Inv. |
| 82 | 21 | 88 | 300 | 3.0 | 3.0 | 0.02 | 13 | 3.0 | 15.5 | - | 1.5 | 4.0 | 0.15 | Inv. |
| 83 | 21 | 88 | 300 | 3.0 | 3.0 | 0.02 | 14 | 2.0 | 13.0 | - | 1.5 | 4.0 | 0.15 | Inv. |
| 84 | 21 | 88 | 300 | 3.0 | 3.0 | 0.02 | 15 | 5.0 | 12.5 | - | 1.5 | 4.0 | 0.15 | Inv. |
| 85 | 28 | 88 | 6000 | 3.0 | 0.7 | 0.01 | 4 | 2.0 | - | 5.0 | 2.0 | 5.0 | 0.15 | Comp. |
| 86 | 29 | 88 | 250 | 3.0 | 6.0 | 0.04 | 4 | 2.0 | - | 5.0 | 3.0 | 5.0 | 0.15 | Comp. |
| 87 | 30 | 88 | 300 | 0.6 | 3.0 | 0.02 | 5 | 2.0 | 14.0 | - | 1.5 | 4.0 | 0.15 | Inv, |
| 88 | 31 | 88 | 300 | 6.2 | 3.0 | 0.02 | 5 | 2.0 | 14.0 | - | 1.5 | 4.0 | 0.15 | Inv. |
| 89 | A | - | - | - | 15.0 | 1.0 | 4 | 4.8 | 13.0 | - | 2.0 | 6.0 | 0.15 | Comp. |

| | | | | | | | | | | | | | | |
|---|---|---|---|---|---|---|---|---|---|---|---|---|---|---|
| **: photopolymerization Initiator (%), Inv.: Inventive, Comp.: Comparative | | | | | | | | | | | | | | |

### <<Production of Printing Plates>>

Printing plates were produced using each of the inks in the same manner as described in Example 1.

### <<Evaluation of Ink>>

### (Evaluation of Intermittent Ejection Properties)

Ejection tests were performed by adjusting the drive voltage wherein the droplet amount from a piezo-type ink-jet heads with 512 nozzles featuring a nozzle diameter of 20 µm and a nozzle resolution of 300 dpi ("dpi" referred to in the present invention represents the number of dots per 2.54 cm) was allowed to be 1 pl. One-minute continuous ejection was carried out under an ambience of 20 °C and 30%RH at a drive frequency of 12 kHz, and thereafter allowed to stop for a certain period of time. Then, the state at the time of resuming the continuous ejection was observed. Intermittent ejection properties were evaluated based on the following criteria.
A: Ejection from all of the nozzles was confirmed after three-minute stop.
B: Some non-ejecting nozzles were observed after three-minute stop, while ejection from all of the nozzles was confirmed after one-minute stop.
C: Some non-ejecting nozzles were observed after one-minute stop.

### <<Evaluation of Printing Plate Images>>

Water-rubbing resistance, ink receptivity, printing durability, dot gain, and ink viscosity suitability were evaluated based on the methods described in Example 2.

The results obtained above are listed in Table 8.

**Table 8**

| Ink No. | Water-rubbing Resistance | Ink recaptivity | Dot Gain | Printing Durability. | Ink Viscosity Suitability | Intermittent Ejection Properties | Remarks |
|---|---|---|---|---|---|---|---|
| 61 | A | A | A | A | A | A | Inv. |
| 62 | A | B | A | A | A | A | Inv. |
| 63 | C | c | A | c | A | A | Inv. |
| 64 | A | B | A | A | A | A | Inv. |
| 65 | A | B | A | A | A | A | Inv. |
| 66 | B | B | A | A | A | A | Inv. |
| 67 | A | B | A | A | A | A | Inv. |
| 68 | B | B | A | A | A | A | Inv. |
| 69 | A | B | A | A | A | A | Inv. |
| 70 | A | B | A | A | A | A | Inv. |
| 71 | C | B | A | B | A | A | Inv. |
| 72 | B | B | B | B | B | B | Inv. |
| 73 | B | B | A | B | B | B | Inv. |
| 74 | A | A | A | A | A | A | Inv. |
| 75 | A | A | A | A | A | A | Inv. |
| 76 | C | B | A | C | A | A | Inv. |
| 77 | A | A | A | A | A | A | Inv. |
| 78 | C | B | A | C | A | A | Inv. |
| 79 | C | A | A | c | A | A | Inv. |
| 80 | B | C | A | C | B | B | Ink. |
| 81 | B | C | B | B | A | B | Inv. |
| 82 | B | B | A | B | A | A | Inv. |
| 83 | B | B | A | B | A | A | Inv. |
| 84 | B | B | A | B | A | A | Inv. |
| 85 | B | C | A | C | B | C | Comp. |
| 86 | C | C | A | C | C | C | Comp. |
| 87 | B | B | A | C | A | A | Inv. |
| 88 | C | B | A | B | A | A | Inv. |
| 89 | B | B | C | C | C | C | Comp. |

| | | | | | | | |
|---|---|---|---|---|---|---|---|
| Inv.: Inventive, Comp.: Comparative | | | | | | | |

The results shown in Table 8 clearly show that the plate making method of the present invention employing a plate making ink containing a polymer and a resin fine particle according to the present invention in an amount specified by the present invention is superior each in water-rubbing resistance, ink receptivity, printing durability, and dot gain, and also the ink exhibits appropriate viscosity characteristics, compared to the comparative examples.

## Claims

1. A plate making method comprising the steps of:
(1) ejecting a plate making ink onto a printing plate material via an ink-jet recording method,
(2) irradiating actinic energy rays onto the ejected plate making ink, and
(3) forming an image via evaporating of an ink solvent followed by drying,
wherein the plate making ink comprises water and an actinic energy ray curable polymer, having a plurality of side chains with a main chain, and cross-linking can be induced among the side chains by irradiation of actinic energy ray radiation, and having a polymerization degree of 200 - 4000, in a range of 0.8% - 5.0 weight% based on the total weight of the ink.

2. The plate making method described in claim 1,
wherein the main chain of the actinic energy ray curable polymer is a saponified compound of polyvinyl acetate and the saponification degree is 77 - 99%.

3. The plate making method described in claim 1 or 2,
wherein a modification rate of the side chains is 0.8 mol% - 6 mol% based on the main chain of the actinic energy ray curable polymer.

4. The plate making method described in any one of claims 1 - 3,
wherein the plate making ink contains resin fine particles of an average particle diameter of 5 - 150 nm in a range of 0.1 - 7 weight%.

5. The plate making method described in claim 4,
wherein the glass transition point of the resin fine particles is -20 to 70 °C.

6. The plate making method described in any one of claims 1 - 5,
wherein the plate making ink contains an alkali-soluble polymer with no cross-linking group, composed of a copolymer of a hydrophilic compound and a hydrophobic compound in a range of 0.1 - 10 weight% based on the total weight of the ink.

7. The plate making method described in claim 6,
wherein an alkaline agent used to solubilize the alkali-soluble polymer is a compound containing an organic base having a vapor pressure of 133 - 1330 Pa at 20 °C or ammonia.

8. The plate making method described in claim 6 or 7,
wherein a weight average molecular weight of the alkali-soluble polymer is 3000 - 20000.

9. A planographic printing plate produced via the plate making method described in any one of claims 1 - 8.

## Patentansprüche

1. Ein Plattenherstellungsverfahren, umfassend die Schritte:
(1) Ausspritzen einer Plattenherstellungstinte auf ein Druckplattenmaterial durch ein Tintenstrahlaufzeichnungsverfahren,
(2) Bestrahlen der ausgespritzten Plattenherstellungstinte mit aktinischen Energiestrahlen, und
(3) Erzeugen des Bildes durch Verdampfen des Tintenlösemittels mit nachfolgender Trocknung,
wobei die Plattenherstellungstinte Nasser und ein durch aktinische Energiestrahlung härtbares Polymer mit einer Mehrzahl von Seitenketten an der Hauptkette enthält, wobei die Vernetzung unter den Seitenketten durch Bestrahlung mit aktinischer Energiestrahlung induziert werden kann, wobei das Polymer einen Polymerisationsgrad von 200 bis 4000 aufweist und die Plattenherstellungstinte das Polymer in einer Menge von 0,8% - 5,0 Gew.-%, bezogen auf das Gesamtgewicht der Tinte, umfasst.

2. Das Plattenherstellungsverfahren nach Anspruch 1, worin die Hauptkette des durch aktinische Energiestrahlung härtbaren Polymers eine verseifte Verbindung von Polyvinylacetat ist und der Verseifungsgrad 77 bis 99% beträgt.

3. Das Plattenherstellungsverfahren nach einem der Ansprüche 1 oder 2, worin der Modifikationsgehalt der Seitenketten 0,8 Mol-% bis 6 Mol-%, bezogen auf die Hauptkette des durch aktinische Energiestrahlung härtbaren Polymers, ist.

4. Das Plattenherstellungsverfahren nach einem der Ansprüche 1 bis 3, worin die Plattenherstellungstinte feine Harzpartikel mit einem durchschnittlichen Partikeldurchmesser von 5 bis 150 nm in einer Menge von 0,1 bis 7 Gew.-% beinhaltet.

5. Das Plattenherstellungsverfahren nach Anspruch 4, worin der Glasübergangspunkt der feinen Harzpartikel -20 bis 70°C ist.

6. Das Plattenherslellungsverfahren nach einem der Ansprüche 1 bis 5, worin die Plattenherstellungstinte ein alkalilösliches Polymer ohne Vernetzungsgruppe beinhaltet, bestehend aus einem Copolymer einer hydrophilen Verbindung und einer hydrophoben Verbindung, in einer Menge von 0,1 bis 10 Gew.-%, bezogen auf das Gesamtgewicht der Tinte.

7. Das Plattenherstellungsverfahren nach Anspruch 6, worin ein alkalischer Stoff, der benutzt wird, um das alkalilösliche Polymer zu lösen, eine Verbindung ist, die eine organische Base mit einem Dampfdruck von 1 33 bis 1 330 Pa bei 20 °C oder Ammoniak beinhaltet

8. Das Plattenherstellungsverfahren nach einem der Ansprüche 6 oder 7, worin das gewichtsmittlere Molekulargewicht des alkalilöslichen Polymers 3000 bis 20000 ist.

9. Eine Flachdruckplatte, hergestellt durch das Pattenherstellungsverfahren nach einem der Ansprüche 1 bis 8.

## Revendications

1. Procédé de fabrication d'une plaque comprenant les étapes de :
(1) éjection d'une encre de fabrication des plaques sur un matériau pour une plaque d'impression par un procédé d'enregistrement par jet d'encre,
(2) irradiation des rayons d'énergie actinique sur l'encre de fabrication des plaques éjectée, et
(3) formation d'une image par l'évaporation d'un solvant de l'encre suivi par un séchage,
dans lequel l'encre de fabrication des plaques comprend de l'eau et un polymère durcissable par les rayons d'énergie actinique présentant une pluralité des chaînes latérales avec une chaîne principale et la réticulation peut être induire parmi les chaînes latérales par l'irradiation des rayons d'énergie actinique et présentant un degré de polymérisation de 200 - 4000 dans une gamme de 0,8 à 5,0 % en poids sur la base du poids total de l'encre.

2. Procédé de fabrication d'une plaque selon la revendication 1, dans lequel la chaîne principale du polymère durcissable par les rayons d'énergie actinique est un composé saponifié de l'acétate de polyvinyle et le degré de saponification est 77 - 99 %.

3. Procédé de fabrication d'une plaque selon l'une des revendications 1 ou 2, dans lequel le taux de modification des chaînes latérales est 0,8 % en mole - 6 % en mole sur la base de la chaîne principale du polymère durcissable par les rayons d'énergie actinique.

4. Procédé de fabrication d'une plaque selon l'une des revendications 1 à 3, dans lequel l'encre de fabrication des plaques contient des particules fines de résine ayant un diamètre moyen de particules de 5 -1 50 nm dans une gamme de 0,1 -7 % en poids.

5. Procédé de fabrication d'une plaque selon la revendication 4, dans lequel le point de transition vitreuse des particules fines de résine est -20 à 70 °C.

6. Procédé de fabrication d'une plaque selon l'une des revendications 1 à 5, dans lequel l'encre de fabrication des plaques contient un polymère soluble dans les alcalis exempt des groupes de réticulation, composé d'un copolymère d'un composé hydrophile et un composé hydrophobique dans une gamme de 0, 7 -10 % en poids sur la base du poids total de l'encre.

7. Procédé de fabrication d'une plaque selon la revendication 6, dans lequel l'agent alcalin utilisé pour solubiliser le polymère soluble dans les alcalis est un composé contentant une base organique ayant une pression de vapeur de 133-1330 Pa à 20 °C ou de l'ammoniac.

8. Procédé de fabrication d'une plaque selon l'une des revendications 6 ou 7, dans lequel le poids moléculaire moyen en poids du polymère soluble dans les alcalis est 300 -20000.

9. Plaque d'impression planographique produite par le procédé de fabrication d'une plaque selon l'une des revendications 1 à 8.
